# EUROPÄISCHE PATENTSCHRIFT

(11) **EP 3 875 436 B1**
(45) Veröffentlichungstag und Bekanntmachung des Hinweises auf die Patenterteilung: **17.01.2024**
(21) Anmeldenummer: 21159711.7
(22) Anmeldetag: 26.02.2021
(51) Int. Cl.: C03B 33/02, B23K 26/0622, B23K 26/53, B23K 26/00, B23K 26/06, B23K 26/064, B23K 26/146, B23K 103/00

(54) **VERFAHREN ZUM VORBEREITEN UND/ODER DURCHFÜHREN DES TRENNENS EINES SUBSTRATELEMENTS UND SUBSTRATTEILELEMENT**
SUBSTRATE ELEMENT AND METHOD FOR PREPARING AND / OR PERFORMING THE SEPARATION OF A SUBSTRATE ELEMENT
PROCÉDÉ DE PRÉPARATION ET/OU DE MISE EN UVRE DE LA SÉPARATION D'UN ÉLÉMENT DE SUBSTRAT ET ÉLÉMENT DE SUBSTRAT

(30) Priorität: 06.03.2020 DE 102020106158; 04.09.2020 DE 102020123186
(43) Veröffentlichungstag der Anmeldung: 08.09.2021
(73) Patentinhaber: SCHOTT AG, 55122 Mainz (DE)
(72) Erfinder: Sohr, David, 55120 Mainz (DE); Wagner, Fabian, 55118 Mainz (DE); Ortner, Andreas, 55435 Gau-Algesheim (DE)
(74) Vertreter: Fuchs Patentanwälte Partnerschaft mbB

(56) Entgegenhaltungen:
- US-A1- 2017 252 859
- US-A1- 2018 345 419

## Beschreibung

Die vorliegende Erfindung betrifft ein Verfahren zum Vorbereiten und/oder Durchführen des Trennens eines Substratelements in wenigstens zwei Substratteilelemente entlang einer Trennfläche und ein Substratteilelement, das insbesondere mit dem erfindungsgemäßen Verfahren hergestellt und/oder herstellbar ist.

### Stand der Technik

In der Glasproduktion und -verarbeitung sowie in artverwandten Bereichen ist es regelmäßig erforderlich, Substratelemente, wie beispielsweise Glaselemente, insbesondere Glasplatten, entlang einer genau definierten Trennfläche zu trennen. Das Einhalten eines vorher definierten Verlaufs der Trennfläche ist beispielsweise für die Interkompatibilität der nach dem Trennen erhaltenen Substratteilelemente mit weiteren Komponenten von großer Bedeutung.

Neben einer insoweit sauberen Trennfläche schreiben Spezifikationen häufig auch das Erfordernis einer hohen Festigkeit von der Trennfläche, also der Kante, vor. Dies hat seinen Grund darin, dass Substratteilelemente, wie insbesondere Glasteilelemente, deren Trennfläche eine hohe Festigkeit aufweisen, insgesamt unempfindlicher gegen äußere Einwirkungen sind. Dadurch kann bis zu einem gewissen Grade ganz oder zumindest teilweise verhindert werden, dass äußere Beschädigungen der Trennfläche überhaupt entstehen und dass etwaig vorhandene Defekte sich in das Innere des Materials fortsetzen.

Gängige und dem Fachmann aus dem Stand der Technik bekannte Verfahren zum Durchführen eines Trennvorgangs sind dabei etwa das thermische Laserstrahl-Separieren (TLS), beispielsweise mittels eines CO₂-Lasers, das mechanische Ritzen, das Laser-Ritzen oder auch das laserbasierte thermische Trennen (laser based thermal shock cutting-Verfahren). Letzteres zielt auf das Fortsetzen eines Initialrisses im Substratelement mittels thermomechanischer Spannungen, typischerweise erzeugt durch einen CO₂-Laser, ab. All diesen Verfahren ist jedoch gemein, dass mit ihnen der Rissverlauf innerhalb des Materials nicht oder nur ungenügend gesteuert werden kann.

Bei dem dem Fachmann ebenfalls bekannten Verfahren der Laser-Perforation werden einzelne Bereiche des zu trennenden Substratelements entlang der gewünschten Trennfläche mit einem Laser im Rahmen eines Ultrakurzpulslaser (UKP)-Prozesses entfernt.

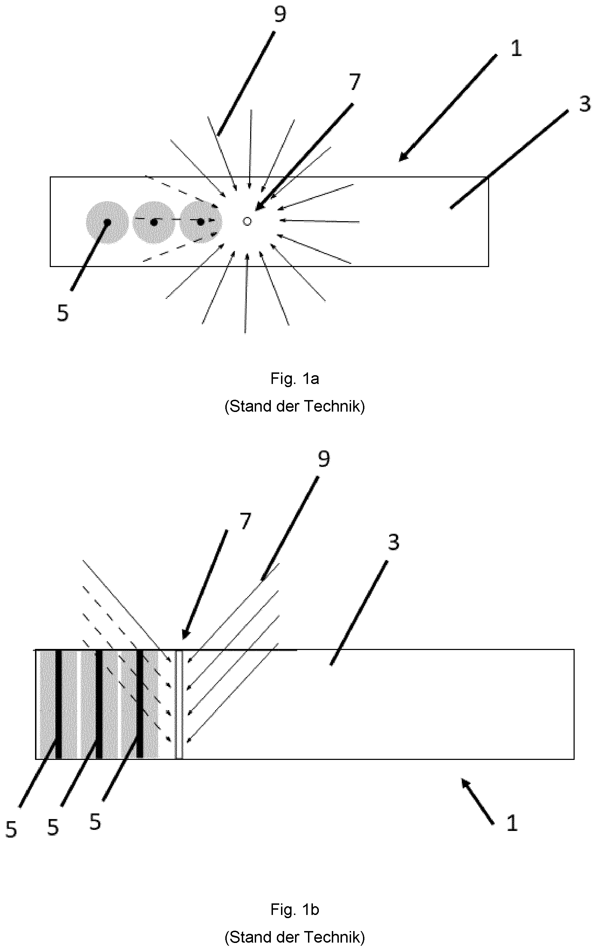

Figur 1a zeigt eine aus dem Stand der Technik bekannte Situation in einer Draufsicht und Figur 1b zeigt dieselbe Situation in einer senkrecht zur Ansicht der Figur 1a verlaufenden Querschnittsansicht. Zu sehen ist in Figur 1a und Figur 1b ein Substratelement 1, das einen Substratkörper 3 umfasst, wobei der Substratkörper 3 ein Substratmaterial aufweist. Beispielsweise kann das Substratelement 1 kann ein Glaselement sein, der Substratkörper 3 kann ein Glaskörper sein und das Substratmaterial kann Glas sein. Das Substratelement 1 ist dazu vorzubereiten, es entlang einer Trennfläche trennen zu können, die in Figur 1b in der Zeichenebene liegt und die durch die Mittelpunkte der kreisförmigen Hohlräume 5 verläuft. Hierfür kommt bei der Laserperforation häufig ein UKP-Lasersystem zum Einsatz, das in dem Substratmaterial einen Linienfokus 7 erzeugt. Damit kann das Substratmaterial an den gewünschten Stellen entfernt werden, um so in dem Substratelement 1 bzw. dem Substratkörper 3 die Hohlräume 5 bzw. Kavitäten als Perforationslöcher zu erzeugen.

Anschließend wird das vorbearbeitete Substratelement 1 beispielsweise durch mechanisches Brechen oder durch Cleaven entlang der durch die Perforationslöcher ausgebildeten Perforationslinie endgültig getrennt.

Es hat sich jedoch gezeigt, dass der Verlauf der Risslinie und damit der Verlauf der Trennfläche im Substratmaterial auch bei diesem Verfahren nur schwer steuerbar ist. So wurde beobachtet, dass beim Brechen die Risslinie von der Perforationslinie abweichen und abseits ebendieser verlaufen kann, was mithin zu einer Trennfläche führen kann, die nicht dem eigentlich gewünschten Verlauf entspricht. Auch die zum Brechen notwendige Kraft ist oftmals vergleichsweise hoch. Und je höher der notwendige Kraftaufwand ist, desto eher gehen von dem Brechvorgang selbst neue Schädigungen des Substratmaterials aus.

Bis zu einem gewissen Grade lässt sich der Verlauf der Trennfläche dadurch besser steuerbar machen, dass die Anzahl an Perforationslöchern entlang der Trennfläche erhöht, mithin also der Abstand zwischen benachbarten Hohlräumen verringert wird. Auch die benötigte Brechkraft lässt sich dadurch reduzieren. Allerdings, so die erstaunliche Beobachtung, zeigt sich, dass ab Unterschreiten eines gewissen Abstands der Hohlräume die Kraft zum anschließenden Brechen nicht mehr weiter sinkt, sondern, im Gegenteil, sogar wieder ansteigt. Dies geht häufig einher mit einer zumindest zeitweisen und/oder bereichsweisen Auslöschung des Linienfokus, so dass zeit- bzw. bereichsweise keine Hohlräume erzeugt werden. Auch die Kontrolle über den Brechvorgang nimmt ab. Damit ist einer weiteren Reduzierung des Abstands unter einen bestimmten Wert eine Grenze gesetzt. Dieser Wert entspricht in etwa dem Zehnfachen der maximalen Ausdehnung des Hohlraums in einer Querschnittsebene senkrecht zur Haupterstreckungsrichtung des Hohlraums.

Es hat sich ferner herausgestellt, dass die entlang der Perforationslinie getrennten Substratteilelemente häufig eine Trennfläche (Kante) haben, die eine nur geringe Festigkeit aufweisen.

Es ist bekannt, dass sich begleitet durch den Perforationsvorgang um die ausgebildeten Kavitäten (Mikro-) Risse im Substratmaterial ausbilden. Neben den grundsätzlich gewünschten Rissen, welche innerhalb der gewünschten Trennfläche liegen und den späteren Trennvorgang unterstützen, bilden sich auch Risse mit anderen Orientierungen aus. Letztere stellen eine Vorschädigung des Substratelements dar und führen später zu einer niedrigeren Kantenfestigkeit der getrennten Substratteilelemente. Durch geeignete Wahl der Laserparameter in Abhängigkeit der Materialeigenschaften kann zwar grundsätzlich Einfluss auf die Ausprägung dieser und anderer Materialschädigungen genommen werden. Beispielsweise kann die Anzahl und die Länge der Risse bis zu einem gewissen Grad kontrolliert werden. Allerdings ist hier ein Kompromiss zwischen späterer Trennbarkeit und Vorschädigung einzugehen.

Mit anderen Worten lässt sich also die herkömmliche Situation auch wie folgt beschreiben: Durch die nichtlineare Wechselwirkung eines UKP-Laserpulses mit dem Substratmaterial entlang der Fokallinie wird im Substrat ein Mikrokanal (Durchmesser oftmals geringer als 1 µm) erzeugt, wobei das Substratmaterial im Innern in die Randbereiche des Kanals gedrückt werden und so dort zu einer Verdichtung führt. Um den Kanal entstehen in radialer Richtung Mikrorisse (in Abhängigkeit von der Pulsleistung). Wird ein Burstpuls verwendet (also der Kanal von mehreren Pulsen im kurzen Zeitraum getroffen), so wird der Bereich um den Kanal von einer Vielzahl längerer Mikrorisse geschädigt. Ist der Pitch, also der Abstand benachbarter Mikrokanäle, groß gegenüber dem Lochdurchmesser und der Länge der Mikrorisse, so können benachbarte Mikrokanäle ohne optische und mechanische Beeinflussung durch seinen jeweiligen Vorläufer erzeugt werden. Mit geringer werdendem Pitch kommt es zunächst zur Abschattung eines Teils der Strahlenergie durch den zuvor erzeugten Mikrokanal, was die Ausbildung des aktuellen Mikrokanals beeinflusst. Des Weiteren wird bei weiter verringertem Pitch das verbleibende Stegmaterial zwischen dem aktuell entstehenden Mikrokanal und seinem benachbarten Vorgänger durch die beiden benachbarten Mikrorisssysteme derart geschwächt, dass es zu einem Zerbrechen des Stegs kommt und das Material in den zuvor erzeugten Mikrokanal gepresst wird, wo es auf Grund der hohen Leistungsdichten wieder anschmilzt bzw. den vorhergehenden Kanal wieder verklebt. Eine derart erzeugte Perforationslinie mit kurzem Pitch weist daher eine deutlich schlechtere Trennbarkeit auf, als von einem unvoreingenommen Betrachter eigentlich erwartet werden würde.

Die US 2018 345 419 A1 betrifft das Gebiet des Lasers und insbesondere die Bearbeitung von transparenten Materialien und kann zum Schneiden, Brechen und für andere Bearbeitungsverfahren von transparenten Materialien, einschließlich Glas, chemisch gehärtetem Glas, Saphir und anderen kristallinen Materialien, durch die Verwendung eines ultrakurz gepulsten asymmetrischen Gauß-Bessel-Laserstrahls mit Intensitätsverteilung verwendet werden.

Die US 2017/252859 A1 betrifft diffraktive optische Elemente, die in optischen Systemen zur Strahlformung eines Laserstrahls und insbesondere zur Strahlformung eines Laserstrahls zur Bearbeitung von Materialien, die für den Laserstrahl im Wesentlichen transparent sind, verwendet werden.

Es ist daher Aufgabe der vorliegenden Erfindung, ein Verfahren anzugeben, mit dem sich Substratelemente in zwar einfacher, aber dennoch sicherer und zuverlässiger Weise trennen lassen können oder das Trennen vorbereitet werden kann, wobei der Verlauf der Trennfläche möglichst genau vorbestimmbar sein und ein etwaiger zum Brechen notwendiger Kraftaufwand möglichst gering ausfallen soll. Gleichzeitig soll auch die Kantenfestigkeit bei den Substratteilelementen verbessert werden. Es ist außerdem Aufgabe der vorliegenden Erfindung, ein Substratteilelement anzugeben, das Seitenflächen (Kanten) mit einer hohen Festigkeit aufweist.

Die Aufgabe wird durch die Erfindung gemäß einem ersten Aspekt dadurch gelöst, dass ein Verfahren zum Vorbereiten und/oder Durchführen des Trennens eines Substratelements in wenigstens zwei Substratteilelemente entlang einer Trennfläche, umfassend die Schritte:
- Bereitstellen des Substratelements, das zumindest einen zumindest ein Substratmaterial aufweisenden Substratkörper umfasst;
- Steuern zumindest eines Linienfokus innerhalb des Substratkörpers derart, dass entlang der Trennfläche zumindest bereichsweise Substratmaterial des Substratkörpers zumindest lokal entfernt und/oder verdrängt wird;

wobei der Linienfokus zumindest einen Fokus zumindest eines Lichtstrahls darstellt; wobei der Lichtstrahl zumindest im Bereich des Linienfokus in Form eines Lichtstrahls mit asymmetrischer Strahlzuführung ausgebildet ist;
wobei bei der asymmetrischen Strahlzuführung die Energie asymmetrisch zugeführt wird, und derart ausgestaltet ist, dass der Schwerpunkt der Energieverteilung in wenigstens einer Ebene senkrecht zur Ebene, in der die Strahlausbreitung erfolgt, im Bereich des bisher nicht modifizierten Substratmaterials liegt, vorgeschlagen wird.

Der Erfindung liegt damit die überraschende Erkenntnis zugrunde, dass Kavitäten zuverlässig und in einheitlich hoher Qualität innerhalb des Substratmaterials ausgebildet werden können, wenn der Lichtstrahl nicht durch bereits ausgebildete Kavitäten beeinflusst wird. Die Erfinder erkannten, dass solch ein Einfluss gerade von unmittelbar benachbarten Kavitäten besonders effektiv dadurch unterbunden werden kann, indem diejenigen lateralen Komponenten des eingesetzten Lichtstrahls reduziert oder ganz eliminiert werden, welche ansonsten mit den bereits ausgebildeten Kavitäten sozusagen "kollidieren". Aufgrund der großen numerischen Apparatur haben aber bei herkömmlichen Linienfoki die Teilstrahlen regelmäßig signifikante laterale Komponenten und damit besteht entsprechend eine große "Kollisionsgefahr".

Gemäß der erfinderischen Lehre erfüllt ein Lichtstrahl mit asymmetrischer Strahlzuführung die Eigenschaft reduzierter bzw. eliminierter lateraler Teilstrahlen in besonders einfacher und effektiver Weise. Dazu wird (beispielsweise mittels einer strahlformenden Optik) die Energie nicht mehr rotationssymmetrisch entlang einer Kegelfläche auf die Fokallinie zugeführt, sondern nun asymmetrisch. Mit anderen Worten, wird also der Lichtstrahl dergestalt ausgeformt, dass er im Gegensatz zu herkömmlicherweise verwendeten Lichtstrahlen keine Anteile aufweist, welche mit den bereits ausgebildeten Kavitäten zusammentreffen können. Dadurch kann sichergestellt werden, dass der Lichtstrahl in hohem Maße unbeeinflusst von bereits ausgebildeten Kavitäten bleibt und somit eine Perforationslinie von besonders hoher Qualität ausgebildet werden kann, da der Linienfokus in gleichbleibend hoher Qualität über den gesamten Dickenbereich des Substratelements ausgebildet werden kann.

Im Zusammenhang mit der Strahlzuführung bzw. Energiezuführung wird vorliegend der Begriff "asymmetrisch" im Sinne von "nicht-rotationssymmetrisch" verstanden. Das bedeutet, dass andere Symmetrien damit nicht ausgeschlossen werden. Zum Beispiel hat der Airy-Strahl eine Spiegelebene parallel zu der Ebene, in welcher sein gekrümmter Verlauf liegt.

Das vorgeschlagene Verfahren trägt damit auf besonders intelligente Weise zu einem verbesserten Trennvorgang und Ergebnis bzw. zur Vorbereitung des Trennens bei, da sowohl eine signifikant verbesserte Steuerung des Verlaufs der Trennfläche bei verminderter Brechkraft erreicht als auch die Kantenfestigkeit verbessert wird.

Gleichzeitig lässt sich das erfindungsgemäße Verfahren aber mit gängigen Mitteln realisieren und damit problemlos in bestehende Anlagen integrieren. So können insbesondere Verfahren, um Substratplatten zuzuschneiden und Substratplattenausschnitte auszulösen, besonders effizient und mit besonders guten Ergebnissen betrieben werden.

Die Erfindung ermöglichte es daher vorzugsweise, dass Substratelemente, insbesondere transparente und/oder sprödbrechende Substratelemente, wie beispielsweise Glaselemente, insbesondere Glasplatten oder Glasscheiben, Glaskeramikelemente, insbesondere Glaskeramikplatten oder Glaskeramikscheiben, und/oder Siliziumelemente, insbesondere Siliziumwafer, selbst mit großen Dicken ab 0,6 mm, insbesondere mit einer Dicke von zwischen 0,6 mm und 10 mm, bevorzugt von zwischen 0,6 mm und 5 mm oder von zwischen 3 mm und 5 mm, noch bevorzugter von zwischen 0,6 mm und 3 mm, noch bevorzugter von zwischen 0,6 mm und 2 mm oder am bevorzugtesten von zwischen 0,6 mm und 1,5 mm, getrennt oder dazu vorbereitet werden können. Alternativ oder ergänzend haben die Substratelemente eine Dicke, die größer als 1 mm, größer als 5 mm oder größer als 10 mm ist. Beispielsweise können die Substratelemente eine Dicke von 1 mm bis zu 50 mm, von 1 mm bis zu 40 mm, von 1 mm bis zu 30 mm, von 1 mm bis zu 20 mm oder von 1 mm bis zu 15 mm aufweisen. Außerdem ist es mit der Erfindung maßgeblich möglich, die Substratelemente mit nur wenigen Überfahrten (d.h. relativen Verschiebungen von Substratelement zu Laser), etwa zwischen 2 und 10 Überfahrten, aber auch mit nur einer einzigen Überfahrt trennen zu können bzw. diese dazu vorzubereiten. Dies ermöglicht einen sehr effizienten Prozess.

Das Verfahren kann dabei allgemein auf transparente, sprödbrechende Substratelemente wie Glas, Glaskeramik, Silizium und Saphir angewendet werden. Damit ist das Verfahren besonders universell einsetzbar.

Anders ausgedrückt ermöglicht es das erfindungsgemäße Verfahren dem Prinzip nach, Substratelemente in einem ersten Schritt durch das Erzeugen von Modifikationen, wie etwa Perforationen, d.h. zum Beispiel schlauchförmigen Kanälen, zu bearbeiten. In einem weiteren Schritt kann entweder durch Beaufschlagung von mechanischen und/oder thermischen Spannungen im Material das Glaselement getrennt werden oder eine geschlossene Innen-/Außenkontur erzeugt werden. Bevorzugt werden Innenkonturen durch einen Ätzprozess erzeugt. Außenkonturen können jedoch grundsätzlich auch, beispielsweise durch nachfolgendes Ätzen, erzeugt werden. Durch die im weiteren Schritt angewandten Verfahren werden allgemein gesprochen die im ersten Schritt erzeugten Kanäle verbunden, beispielsweise entweder durch Risse oder durch Wegnehmen von Material.

Der Fachmann versteht dabei, dass bei einem asymmetrischen Strahl eine asymmetrische Anordnung der Teilstrahlen vorliegt, aber selbstverständlich grundsätzlich nicht mehrere Strahlengänge für die asymmetrische Strahlzuführung genutzt werden.

Der Fachmann versteht dabei, dass der Linienfokus grundsätzlich innerhalb des Substratkörpers ausgebildet sein muss. Dies schließt dabei Fälle ein, in denen der Linienfokus komplett innerhalb des Substratkörpers ausgebildet ist, also außerhalb des Substratkörpers kein Linienfokus ausgebildet ist. Dabei ist dann der Linienfokus vorzugsweise bis zur Oberfläche des Substratkörpers innerhalb des Substratkörpers ausgebildet, oder aber der Linienfokus ist bis zu einem gewissen Abstand, etwa einem Abstand von bis zu 2 µm, von bis zu 1 µm oder von bis zu 0,5 µm, zur jeweiligen Oberfläche innerhalb des Substratkörpers ausgebildet. Aber es sind freilich auch Fälle eingeschlossen, in denen der Linienfokus zwar auch im Substratkörper ausgebildet ist, sich aber auch außerhalb davon erstreckt. In der Tat stellt dies sogar einen bevorzugten Fall dar.

Wenn entlang der Trennfläche zumindest bereichsweise Substratmaterial des Substratkörpers zumindest lokal entfernt und/oder verdrängt wird, so erfolgt dies vorzugsweise durch den Linienfokus. Mit anderen Worten, indem der Linienfokus innerhalb des Substratkörpers gesteuert wird, entfernt bzw. verdrängt der Linienfokus entlang der Trennfläche zumindest bereichsweise Substratmaterial des Substratkörpers

In bevorzugten Ausführungsformen stellt das Substratelement ein Glaselement in Form einer Glasscheibe dar oder umfasst diese.

Der Fachmann versteht dabei, dass, wenn etwas "entlang" der Trennfläche erfolgt, beispielsweise das Entfernen von Substratmaterial des Substratkörpers, die Trennfläche zu dem Zeitpunkt noch nicht zwingend komplett vorhanden sein muss, da sie erst nach dem Trennen des Substratelements in die beiden Substratteilelemente vollständig ausgebildet ist. Stattdessen handelt es sich dann um die geplante Trennfläche.

Daher kann in bevorzugten Ausführungsformen das Verfahren ferner alternativ oder ergänzend den Schritt umfassen: Festlegen einer geplanten Trennfläche des Substratelements.

Alles, was sich auf die Trennfläche im noch nicht getrennten Substratelement bezieht, bezieht sich dann auf die geplante Trennfläche. Beispielsweise umfasst dann das Steuern des Linienfokus, dass entlang der geplanten Trennfläche zumindest bereichsweise Substratmaterial des Substratkörpers zumindest lokal entfernt und/oder verdrängt wird.

Mit dem vorgeschlagenen Verfahren kann der Verlauf der Risslinie und damit der Verlauf der Trennfläche im Substratmaterial besonders zuverlässig kontrolliert werden. Auch die benötigte Brechkraft kann gesenkt werden, was weitere Schädigungen beim Brechen vermeidet. Denn die einzelnen Kavitäten lassen sich enger beieinander positionieren. Auch die Festigkeit der Trennfläche kann erhöht werden, insbesondere da durch das Verfahren weniger oder sogar gar keine Mikrorisse eingebracht werden.

Alternativ oder ergänzend kann auch vorgesehen sein, dass bei der asymmetrischen Strahlzuführung (i) die Energie asymmetrisch zugeführt wird, und derart ausgestaltet ist, dass der Schwerpunkt der Energieverteilung in wenigstens einer Ebene senkrecht zur Ebene, in der die Strahlausbreitung erfolgt, im Bereich des bisher nicht modifizierten Substratmaterials, also auf der von der vorhergehenden Kavität abgewandten Seite, liegt; (ii) die Teilstrahlen des Lichtstrahls nur aus einer halben Raumhälfte, oder einem Teil davon, einfallen; (iii) wobei der Lichtstrahl einen Polwinkel p von 0° < p < 90° aufweist und/oder sich die Teilstrahlen des Lichtstrahls innerhalb eines Azimutwinkel-Bereichs von kleiner als 180°, vorzugsweise von zwischen 85° und 100°, insbesondere von zwischen 90° und 95°, befinden; (iv) die Teilstrahlen des Lichtstrahls nur aus Richtungen einfallen, die so gewählt sind, dass sie nicht durch Bereiche des Substratkörpers propagieren, aus denen bereits Substratmaterial entfernt und/oder verdrängt wurde und/oder in die Substratmaterial hineinverdichtet wurde; (v) der Lichtstrahl zumindest eine Spiegelebene parallel zu der Ebene, in der die Strahlausbreitung erfolgt, aufweist; (vi) der Begriff "asymmetrisch" im Sinne von "nicht-rotationssymmetrisch" zu verstehen ist, insbesondere also andere Symmetrien nicht ausgeschlossen sind; und/oder (vii) die Teilstrahlen des Lichtstrahls in jeder zu zumindest einer Oberfläche des Substratelements parallelen Ebene und/oder in jeder zur optischen Achse des Lichtstrahls senkrechten Ebene nur aus einem oder nur aus zwei Quadranten einfallen.

Wird die Energie asymmetrisch zugeführt, und zwar vorzugsweise derart ausgestaltet, dass der Schwerpunkt der Energieverteilung in der Ebene senkrecht zur Strahlausbreitungsrichtung im Bereich des bisher nicht modifizierten Materials, also auf der von der vorhergehenden Kavität abgewandten Seite, liegt, kann besonders effektiv verhindert werden, dass der Linienfokus durch bereits vorhandene Kavitäten beeinflusst wird.

Durch die asymmetrische Energiezuführung, mithin durch die asymmetrische Strahlzuführung, wird erreicht, dass die Laser-Energie nicht mehr - in einer Ebene senkrecht zur optischen Achse betrachtet - rotationssymmetrisch aus allen Richtungen entlang einer Fokallinie fokussiert wird.

Der Begriff "(nicht) aus allen Richtungen" bezieht sich daher auf die Komponente in der transversalen Ebene, d.h. in der Ebene senkrecht zur optischen Achse. Die Komponente entlang der optischen Achse zeigt immer in Propagationsrichtung des Laserstrahls.

Sowohl Airy- als auch Besselstrahl weisen beide einen Polwinkel p mit 0° < p < 90° auf. Dabei ist die Polrichtung als die Propagationsrichtung des Laserstrahlschwerpunkts, bzw. die Polachse als parallel zur optischen Achse definiert.

Beim Airy-Strahl ist die Intervallbreite der Azimutwinkel der Teilstrahlen kleiner als 180°, beispielsweise zwischen 90° und 95°. Oder anders ausgedrückt: In Polarkoordinaten betrachtet überstreicht der Azimutwinkel nicht mehr 360°, also nicht mehr alle Richtungen, sondern nur noch einen Ausschnitt davon.

In bevorzugten Ausführungsformen ist es der Fall, dass eine gebogene Fokuslinie vorliegt. Der Fachmann spricht in solchen Fällen auch von einem "beschleunigten Lichtstrahl".

Die Teilstrahlen können in einer halben Raumhälfte oder einem Teil davon verlaufen, so ist sichergestellt, dass die Teilstrahlen stets im noch unbearbeiteten Materialbereich verlaufen.

Es ist bevorzugt, dass für die asymmetrische Strahlzuführung die Teilstrahlen und ihre Einfallsrichtung in einer Ebene betrachten werden, wobei die Ebene vorzugsweise senkrecht zu einer Ebene, in der die Strahlausbreitung erfolgt, ist.

Alternativ oder ergänzend kann auch vorgesehen sein, dass der Lichtstrahl zumindest einen Laserstrahl umfasst, der Lichtstrahl zumindest im Bereich des Linienfokus als Airy-Strahl oder als Bessel-Strahl ausgebildet ist und/oder die Laser-Energie entlang der Fokallinie des Linienfokus fokussiert wird.

Ein Airy-Strahl eignet sich besonders gut für eine asymmetrische/seitliche Strahlzuführung. Ein Bessel-Strahl eignet sich besonders gut für eine symmetrische/radiale Strahlzuführung.

Ein Airy-Strahl oder ein Bessel-Strahl lassen sich außerdem besonders einfach und effizient erzeugen.

So kann etwa ein Gauß-Strahl als Ausgangsbasis dienen, der mittels geeigneter Optiken, wie etwa ein Axikon, dann zu einem Bessel-Strahl geformt wird.

Als Ausgangsstrahl für einen Airy-Strahl kann ein Gauss-Strahl verwendet werden. Auf diesen Gauss-Strahl wird dann eine kubische Phase angewendet, etwa mittels Phasenmaske, wie ein DOE oder SLM, oder Zylinderlinsen. Dieser Strahl mit kubischer Phase wird anschließend abgebildet, etwa mit einem Mikroskop-Objektiv. Das heißt mit anderen Worten, dass sich ein Airy-Strahl als Abbildung eines Strahls mit kubischer Phase, die entweder direkt durch eine Phasenmaske (DOE oder SLM) oder einen Aufbau mit Zylinderlinsen erzeugt wird, ergeben kann. Mit nochmals anderen bzw. ergänzenden Worten wird dabei der Airy-Strahl als Fourier-Transformierte der kubischen Phase erzeugt. Für eine Ausprägung der Fourier-Transformation mit ebener Phase, d.h. für eine möglichst optimale Propagation vor und nach der Fourier-Ebene, wird die kubische Phase vorzugsweise in der "front focal plane", d.h. der Fokusebene vor der Abbildungsoptik, aufgeprägt. Die Fourier-Ebene entspricht dabei der hinteren Brennebene ("back focal plane") der Abbildungsoptik.

Alternativ oder ergänzend kann auch vorgesehen sein, dass das Steuern des Linienfokus umfasst, dass der Linienfokus nacheinander innerhalb unterschiedlicher Ortsbereiche des Substratmaterials ausgebildet wird und dadurch das Substratmaterial jeweils dieser Ortsbereiche entfernt und/oder verdrängt wird, insbesondere das Substratmaterial in einen Teil des den jeweiligen Ortsbereich umgebenen Substratkörpers hineinverdichtet wird, wobei vorzugsweise die einzelnen Ortsbereiche, insbesondere in zumindest einer, vorzugsweise senkrecht zur Trennfläche, senkrecht zur optischen Achse des Lichtstrahls und/oder parallel zu zumindest einer ersten Oberfläche des Substratelements verlaufenden, ersten spezifischen Querschnittsebene des Substratelements, entlang eines geradlinigen Pfades verlaufen.

Indem verschiedene Ortsbereiche des Substratmaterials zum Ausbilden des Linienfokus ausgewählt werden, kann der Verlauf und die Ausbildung der Perforationslöcher gezielt festgelegt werden. Insbesondere lassen sich damit diskrete Orte innerhalb des Substratkörpers bzw. des Substratmaterials auswählen, an denen Perforationslöcher eingebracht werden sollen.

Zum Ausbilden einer geradlinigen Trennfläche können die einzelnen Ortsbereiche so gewählt werden, dass sie entlang eines geradlinigen Pfades verlaufen.

Der Fachmann versteht dabei, dass ein Ortsbereich des Substratmaterials grundsätzlich größer sein kann als der Bereich, den der Linienfokus im Substratmaterial einnimmt. Ein Ortsbereich bestimmt sich dadurch, dass in diesem das Substratmaterial durch den Linienfokus entfernt und/oder verdrängt wird. Beispielsweise kann innerhalb des Substratkörpers das Substratmaterial vorwiegend verdrängt und im Oberflächenbereich des Substratkörpers kann das Substratmaterial vorwiegend entfernt werden.

Alternativ oder ergänzend kann auch vorgesehen sein, dass der Linienfokus und/oder die Ortsbereiche so gewählt ist bzw. sind, dass die größte Ausdehnung der Ortsbereiche in der ersten spezifischen Querschnittsebene zwischen 0,2 µm und 200 µm, bevorzugt zwischen 0,2 µm und 100 µm, noch bevorzugter zwischen 0,2 µm und 50 µm, noch bevorzugter zwischen 0,3 µm und 20 µm, noch bevorzugter zwischen 0,3 µm und 10 µm, und am bevorzugtesten 0,7 µm, beträgt.

Wenn die Ausdehnung der Ortsbereiche, mithin die Ausdehnung der Bereiche, aus denen Material entfernt bzw. verdrängt wird, geeignet gewählt wird, kann eine besonders vorteilhafte Perforationslinie für die anschließende Trennung durch beispielsweise mechanisches Brechen erhalten werden.

Alternativ oder ergänzend kann auch vorgesehen sein, dass jeweils benachbarte Ortsbereiche in der ersten spezifischen Querschnittsebene, insbesondere entlang des Pfades, einen Mitte-Mitte-Abstand zueinander aufweisen, der zwischen dem 1-fachen und 500-fachen, vorzugsweise zwischen dem 1-fachen und 100-fachen, noch bevorzugter zwischen dem 1-fachen und dem 50-fachen, noch bevorzugter zwischen dem 1-fachen und 10-fachen, noch bevorzugter zwischen dem 1,1-fachen und 5-fachen, der größten Ausdehnung der Ortsbereiche in der ersten spezifischen Querschnittsebene entspricht und/oder der zwischen 0,1 µm und 500 µm, bevorzugt zwischen 0,2 µm und 400 µm, noch bevorzugter zwischen 0,2 µm und 200 µm, noch bevorzugter zwischen 0,2 µm und 100 µm, noch bevorzugter zwischen 0,2 µm und 50 µm, noch bevorzugter zwischen 0,4 µm und 20 µm, noch bevorzugter zwischen 1 µm und 7 µm, und am bevorzugtesten zwischen 1 µm und 3 µm, beträgt.

Indem der Abstand benachbarter Ortsbereiche in Abhängigkeit der Ausdehnung der Ortsbereiche gewählt wird, reicht zum Trennen des Substratelements eine besonders geringe Kraft aus. Dies führt zu besonders wenig zusätzlichen Schädigungen im Substratmaterial. Dies wiederum begünstigt, eine besonders hohe Festigkeit der Trennfläche zu erreichen. Gleichermaßen kann aber auch durch die absolute Angabe eines Abstandes ein besonders vorteilhaftes Trennverhalten erreicht werden.

Alternativ oder ergänzend kann auch vorgesehen sein, dass das Steuern des Linienfokus umfasst, dass der Linienfokus nacheinander innerhalb unterschiedlicher Wirkbereiche im Substratelement, insbesondere im Substratkörper, erzeugt und dadurch das innerhalb jeweils dieser Wirkbereiche angeordnete Substratmaterial entfernt und/oder verdrängt wird, insbesondere das Substratmaterial in einen Teil des den jeweiligen Wirkbereich umgebenen Substratkörpers hineinverdichtet wird, und wobei der Abstand der einzelnen Wirkbereiche derart gewählt ist, dass zumindest unmittelbar benachbarte Wirkbereiche zumindest teilweise überlappen, so dass ein durchgehender, substratmaterialfreier Korridor im Substratmaterial entlang der Trennfläche ausgebildet wird, wobei vorzugsweise die einzelnen Wirkbereiche, insbesondere in zumindest einer, vorzugsweise senkrecht zur Trennfläche, senkrecht zur optischen Achse des Lichtstrahls und/oder parallel zu zumindest einer zweiten Oberfläche des Substratelements verlaufenden, zweiten spezifischen Querschnittsebene des Substratelements, entlang eines geradlinigen Pfades verlaufen.

Indem verschiedene Wirkbereiche zum Ausbilden des Linienfokus sozusagen ineinander gesetzt werden und, da jeweils das gesamte innerhalb des Wirkbereichs vorhandene Substratmaterial entfernt bzw. verdrängt wird, kann entlang der Trennfläche sogar die unmittelbare Trennung des Substratelements erreicht werden. Dadurch wird der zusätzliche Schritt des mechanischen Brechens entbehrlich.

Zum Ausbilden einer geradlinigen Trennfläche können die einzelnen Wirkbereiche so gewählt werden, dass sie entlang eines geradlinigen Pfades verlaufen.

Vorteilhafterweise ermöglicht es der "Korridor", dass sowohl Innen- als auch Außenteile abgetrennt werden können. Das heißt, es können aus einem Substrat auch innenliegende Teile entfernt werden. Beispielsweise kann aus einem (quaderförmigen) Substrat eine kreisförmige Öffnung entfernt werden, so dass ein Loch in dem Substrat besteht. Je nachdem, ob es sich um eine Innen- oder Außenkontur handelt, kann dabei etwa mechanisches Brechen zum Einsatz kommen und/oder Ätzen. Gerade bei Innenkonturen kann üblicherweise kein mechanisches Brechen zum Einsatz kommen.

Der Fachmann versteht dabei, dass ein Wirkbereich grundsätzlich größer sein kann als der Bereich, den der Linienfokus einnimmt. Ein Wirkbereich bestimmt sich dadurch, dass in diesem das Substratmaterial durch den Linienfokus entfernt bzw. verdrängt wird. Entsprechend ist klar, dass die einzelnen Wirkbereiche nicht vollständig mit Substratmaterial gefüllt sein müssen, sondern dass nur das Substratmaterial, das dort enthalten ist, auch entfernt bzw. verdrängt wird.

In einer Ausführungsform ist die zweite spezifische Querschnittsebene des Substratelements gleich der ersten spezifischen Querschnittsebene des Substratelements.

In einer Ausführungsform ist die zweite Oberfläche des Substratelements gleich der ersten Oberfläche des Substratelements.

Alternativ oder ergänzend kann auch vorgesehen sein, dass der Linienfokus und/oder die Wirkbereiche so gewählt ist bzw. sind, dass die größte Ausdehnung der Wirkbereiche in der zweiten spezifischen Querschnittsebene zwischen 0,2 µm und 200 µm, bevorzugt zwischen 0,2 µm und 100 µm, noch bevorzugter zwischen 0,2 µm und 50 µm, noch bevorzugter zwischen 0,3 µm und 20 µm, noch bevorzugter zwischen 0,3 µm und 10 µm, und am bevorzugtesten 0,7 µm, beträgt.

Wenn die Ausdehnung der Wirkbereiche, mithin die der Bereiche, aus denen Material entfernt bzw. verdrängt wird, geeignet gewählt wird, kann besonders effizient der "Korridor" durch das Substratmaterial vorangetrieben werden. Je größer der einzelne Wirkbereich gewählt wird, desto geringer fällt die Anzahl an notwenigen ineinandergesetzten Wirkbereiche aus.

Alternativ oder ergänzend kann auch vorgesehen sein, dass jeweils benachbarte Wirkbereiche in der zweiten spezifischen Querschnittsebene, insbesondere entlang des Pfades, einen Mitte-Mitte-Abstand aufweisen, der zwischen dem 0,01-fachen und dem 1,0-fachen, bevorzugt zwischen dem 0,01-fachen und dem 0,5-fachen, der größten Ausdehnung der Wirkbereiche in der zweiten spezifischen Querschnittsebene entspricht und/oder der zwischen 0,002 µm und 200 µm, bevorzugt zwischen 0,002 µm und 100 µm, noch bevorzugter zwischen 0,002 µm und 50 µm, noch bevorzugter zwischen 0,002 µm und 10 µm, noch bevorzugter zwischen 0,002 µm und 1 µm, am bevorzugtesten zwischen 0,005 µm und 0,3 µm, beträgt.

Indem der Abstand benachbarter Wirkbereiche in Abhängigkeit der Ausdehnung der Wirkbereiche gewählt wird, kann der Korridor in optimierter Bearbeitungsdauer erzeugt werden. Ferner kann damit eine besonders hohe Festigkeit der Trennfläche erreicht werden. Gleichermaßen kann aber auch durch die absolute Angabe eines Abstandes ein besonders vorteilhaftes Trennverhalten erreicht werden.

Alternativ oder ergänzend kann auch vorgesehen sein, dass die Ortsbereiche und/oder Wirkbereiche im Substratmaterial zumindest bereichsweise schlauchförmig, zylinderförmig und/oder gekrümmt, insbesondere in zumindest einer Querschnittsebene sichelartig, verlaufen und/oder sich vorzugsweise von der ersten bzw. zweiten Oberfläche des Substratkörpers zur der Oberfläche gegenüberliegenden Oberfläche des Substratkörpers durch den gesamten zwischen den beiden Oberflächen eingeschlossenen Dickenbereich des Substratkörpers hindurch erstrecken.

In bevorzugten Ausführungsformen erstrecken sich die Wirkbereiche und/oder Ortsbereiche in einer Richtung parallel zur Trennfläche und/oder senkrecht zu der Haupterstreckungsrichtung der Trennfläche und/oder des Pfades.

In bevorzugten Ausführungsformen liegen die lokalen Tangenten der Wirkbereiche und/oder Ortsbereiche in der Ebene, die durch den gebogenen Linienfokus definiert wird.

Alternativ oder ergänzend kann auch vorgesehen sein, dass das Steuern des Linienfokus umfasst, dass das Substratelement relativ zu dem zumindest einen Lichtstrahl und/oder zu dem Linienfokus verfahren wird, wodurch vorzugsweise der Linienfokus, insbesondere nacheinander oder kontinuierlich, zumindest an den unterschiedlichen Orts- und/oder Wirkbereichen ausgebildet werden kann.

Der Linienfokus kann in den einzelnen Orts- und/oder Wirkbereiche in besonders einfacher und zuverlässiger Weise dadurch ausgebildet werden, dass das Substratelement relativ zu dem Lichtstrahl verfahren wird. Somit müssen die für die Erzeugung des oder der Lichtstrahlen notwenigen Geräte und Optiken dafür nicht verändert werden, wenngleich sie es grundsätzlich könnten. Damit kann sozusagen nach jedem relativen Verfahren des Substratelements der Linienfokus neu ausgebildet werden, welcher sich aufgrund des Verfahrens des Substratelements jedes Mal in einem neuen Orts- bzw. Wirkbereich befindet. Alternativ kann der Linienfokus auch laufend ausgebildet bleiben, während das Substratelement relativ verfahren wird. Vorzugsweise eignet sich diese Variante für die Ausbildung eines Korridors, also die vollständige Trennung des Substratelements.

In bevorzugten Ausführungsformen erfolgt eine Nachführung und/oder Anpassung der Strahlgeometrie.

Der Fachmann weiß, dass eine kontinuierliche Ausbildung des Linienfokus im Falle eines gepulsten Lasers nicht möglich ist, dass aber der mit einem solchen Laser ausgebildete Linienfokus im Sinne der Erfindung sehr wohl "kontinuierlich an den unterschiedlichen Orts- und/oder Wirkbereichen" ausgebildet werden kann. Dies bedeutet dann nämlich nichts anderes, als dass sich der Ort, an dem der Linienfokus ausgebildet wird kontinuierlich ändert.

Alternativ oder ergänzend kann auch vorgesehen sein, dass der oder die Lichtstrahlen (i) eine Wellenlänge von zwischen 300 nm und 1500 nm, insbesondere 343 nm, 355 nm, 515 nm, 532 nm, 1030 nm oder 1064 nm, aufweist bzw. aufweisen, (ii) eine Wellenlänge aus dem Transparenzbereich des Substratmaterials aufweisen, und/oder (iii) von zumindest einem gepulsten Laser, insbesondere einem Ultrakurzpulslaser, mit einer Pulsdauer von zwischen 200 fs und 50 ps, vorzugsweise von zwischen 500 fs und 10 ps, einer Pulszahl im Burst von zwischen 1 und 10, vorzugsweise 4, eine Repetition Rate von zwischen 1 kHz und 4 GHz, vorzugsweise 40 MHz, und/oder einer Pulsenergie von zwischen 80 µJ/mm und 300 µJ/mm, vorzugsweise 100-230 µJ/mm, insbesondere 180 µJ/mm, emittiert werden.

Der Linienfokus lässt sich mit bevorzugten Parametern des Lichtstrahls bzw. des Laserstrahls in besonders robuster und zuverlässiger Weise ausbilden.

UKP-Laser haben eine hohe Leistungsdichte, dadurch können nicht-lineare Effekte des Substratmaterials ausgenutzt werden. Insbesondere können Fokus-Effekte ausgenutzt werden, wodurch kleinere Kavitäten möglich sind.

Einen Burst charakterisierend ist, dass mehrere Pulse in einem kurzen Zeitraum, also beispielsweise innerhalb eines Zeitfensters von kleiner als 1 µs, vorzugsweise von kleiner als 0,1 µs oder sogar kleiner als 0,01 µs, mit einem Abstand zwischen zwei Pulsen von kleiner als 50 ns aufeinander folgen. Diese können im Allgemeinen auch jeweils die gleiche Energie, insbesondere Pulsspitzenleistung, aufweisen.

Alternativ oder ergänzend kann auch vorgesehen sein, dass das Substratelement zumindest während das Substratmaterial entfernt und/oder verdrängt wird zumindest teilweise und/oder bereichsweise von zumindest einem Fluid umgeben und/oder zumindest teilweise und/oder bereichsweise innerhalb des Fluids angeordnet ist, so dass das Fluid an Stelle des entfernten bzw. verdrängten Substratmaterials treten kann, wobei vorzugsweise der Lichtstrahl zumindest eine Wellenlänge umfasst und das Fluid für die Wellenlänge des Lichtstrahls einen Brechungsindex aufweist, der höchstens 30 % vom Brechungsindex des Substratkörpers abweicht, und/oder einen Brechungsindex von zwischen 1,2 und 2,5 aufweist; insbesondere das Fluid eine Flüssigkeit umfasst, einen Brechungsindex aufweist, der höchstens 20 %, 10 %, 7 %, 5 %, 3 % oder 1 % vom Brechungsindex des Substratkörpers abweicht und/oder einen Brechungsindex von zwischen 1,2 und 2,1, vorzugsweise von zwischen 1,3 und 1,6, aufweist.

Es zeigte sich, dass das beobachtete Ansteigen der aufzuwendenden Brechkraft mit verringertem Abstand der einzelnen Hohlräume wohl auch damit zusammenhängt, dass das Ausbilden des einen Hohlraums zu einem Verfüllen des benachbarten, unmittelbar vorher erzeugten, Hohlraums mit Substratmaterial führen konnte. Womöglich ist dies die Folge von geschmolzenem und wieder erstarrtem Substratmaterial oder von Substratmaterial, das beim Ausbilden der neuen Kavität in den Substratkörper (bzw. in die Wand zwischen benachbarten Kavitäten) verdichtet und von dort in die benachbarte Kavität gedrückt wird.

Durch die Anwesenheit des Fluids in bestehenden Kavitäten konnten diese erfolgreich davor bewahrt werden, wieder ganz oder teilweise mit Substratmaterial verfüllt zu werden, wenn in ihrer Nachbarschaft neue Kavitäten ausgebildet werden. Da das Fluid inkompressibel ist, wird die bestehende Kavität offenbar durch das Fluid mechanisch stabilisiert. Wenn benachbart eine neue Kavität ausgebildet wird, wird somit wirkungsvoll verhindert, dass Substratmaterial in die bereits bestehende Kavität gedrückt wird. Es wird mit anderen Worten eine Gegenkraft auf das Material zwischen der entstehenden Kavität und der vorhergehenden Kavität ausgeübt.

Durch die Verhinderung einer Entlastung einer neuen Kavität durch vorherige Kavitäten wurde ferner ein verbessertes Vorspannen der Kante der Trennfläche beobachtet, wodurch eine höhere Kantenstabilität erreicht wird. Die Erfinder erklären sich diesen Effekt damit, dass dadurch, dass während dem Ausbilden einer Kavität das Material anstatt in benachbarte Kavitäten dann vermehrt in die die Kavität umgebene Wandung gedrückt wird, eine radiale Druckspannung in der verdichteten Wand angelegt wird. In den getrennten Substratteilelementen entspricht dies dann einer verdichteten Zone, mithin also einer Druckspannungszone, parallel zur Trennfläche.

Gleichzeitig stellten die Erfinder auch fest, dass sich mit einem Fluid Oberflächeneffekte, beispielsweise bei einem Laserprozess, verhindern oder zumindest reduzieren lassen. D.h. die Schwellenintensität für eine Plasmazündung an der Substratoberfläche wird optimiert, wenn die Oberfläche des Substratelements mit dem Fluid benetzt ist oder sich das Substratelement als Ganzes im Fluid befindet. Dadurch wird eine größere Homogenität der Kavitäten auf der gesamten Länge erreicht.

Außerdem kann das Fluid innerhalb der Kavitäten dazu beitragen, dass jede denkbare weitere Beeinflussung des Linienfokus durch benachbarte Kavitäten noch weiter verringert wird. Und zwar mit umso besseren Ergebnissen, je näher der Brechungsindex des Fluids an dem des Substratmaterials gewählt wird. Den Grund dafür vermuten die Erfinder darin, dass bei angepasstem Brechungsindex geringere oder sogar keine Energieverluste an den Grenzflächen stattfinden.

Wenn ein Fluid anwesend ist und beispielsweise die Wirkbereiche verfüllt, kann eine Brechung und/oder Streuung von Teilstrahlen des Lichtstrahls an der freien Oberfläche des oder der vorhergehenden Wirkbereiche in der Nähe des Linienfokusses signifikant reduziert werden. Dadurch lässt sich deutlich gezielter die Trennfläche realisieren.

Wenn der Brechungsindex dem des Substratmaterials entspricht oder nahekommt, ist der Einsatz des Fluids besonders wirkungsvoll.

Alternativ oder ergänzend kann auch vorgesehen sein, dass (i) das Substratelement ein Glaselement, ein Glaskeramikelement, ein Siliziumelement und/oder ein Saphirelement umfasst oder darstellt und/oder zumindest bereichsweise in Form einer Platte und/oder eines Wafers, insbesondere eines Silizium-Wafers, ausgebildet ist; (ii) der Substratkörper ein Glaskörper, ein Glaskeramikkörper, ein Siliziumkörper und/oder ein Saphirkörper umfasst oder darstellt; und/oder (iii) das Substratmaterial Glas, Glaskeramik, Silizium und/oder Saphir umfasst oder daraus besteht.

Die Aufgabe wird durch die Erfindung gemäß einem zweiten Aspekt dadurch gelöst, dass ein Substratteilelement, insbesondere hergestellt und/oder herstellbar mit einem Verfahren gemäß dem ersten Aspekt der Erfindung, umfassend zumindest einen zumindest ein Glasmaterial, Glaskeramikmaterial und/oder Silizium aufweisenden Körper, der zumindest eine Seitenfläche aufweist, wobei die Seitenfläche zumindest bereichsweise eine in der Höhe modulierte Oberfläche aufweist, vorgeschlagen wird.

Der Erfindung liegt damit die überraschende Erkenntnis zugrunde, dass für eine Seitenfläche eine hohe Festigkeit erreicht werden kann, indem künstlich sozusagen eine kleine Unebenheit eingebracht wird. Die Erfinder haben erkannt, dass eine Höhenmodulation offenbar zu einer Stabilisierung der Seitenfläche und damit auch zu einer höheren Kantenfestigkeit führt.

Die Erfinder erklären sich diese positive Eigenschaft damit, dass durch die Höhenmodulation positive Spannungseigenschaften in dem Körper auftreten, welche zu einer insgesamt höheren Festigkeit beitragen.

Der Fachmann versteht, dass in bevorzugten Ausführungsformen die Höhe bzw. Modulation der Oberfläche entlang einer Richtung verlaufen kann, die senkrecht zur Haupterstreckungsrichtung der Oberfläche ist.

Alternativ oder ergänzend kann auch vorgesehen sein, dass die Höhenmodulation der Oberfläche eine wellenförmige Oberfläche darstellt und/oder die Variation der Oberfläche in Folge der Höhen-Modulation innerhalb eines vorgebbaren Wertebereichs liegt, insbesondere innerhalb eines Wertebereichs von 0,5 µm bis 100 µm, bevorzugt innerhalb eines Wertebereichs von 0,5 µm bis 50 µm.

Wenn die Höhenmodulation der Oberfläche zu einer Welligkeit der Oberfläche führt, lassen sich dort besonders hohe Festigkeitswerte erreichen.

Bevorzugte Wertebereiche führen zu bevorzugt hohen Festigkeiten. Es versteht sich hier von selbst, dass Variation die Differenz zwischen Maximal- und Minimalwert der Höhe beschreibt.

Alternativ oder ergänzend kann auch vorgesehen sein, dass (i) die Seitenfläche zumindest bereichsweise eine, vorzugsweise mittlere, Rautiefe von zwischen 0,01 µm bis 30 µm, bevorzugt von zwischen 0,05 µm bis 10 µm, am bevorzugtesten von zwischen 0,05 µm bis 5 µm, RZ aufweist, (ii) die Seitenfläche zumindest bereichsweise eine, vorzugsweise mittlere, Oberflächenrauheit aufweist, und/oder (iii) die Variation der Oberfläche in Folge der Rautiefe und/oder Oberflächenrauheit zwischen 1 und 5, vorzugsweise 2 oder 3, Größenordnungen geringer als die Variation der Oberfläche in Folge der Höhenmodulation ist.

Parallel zur Höhenmodulation hat sich eine möglichst geringe Oberflächenrauheit bzw. Rautiefe als besonders vorteilhaft für hohe Festigkeiten erwiesen und führt damit zu einem besonders stabilen und daher gut einsetzbaren Substratteilelement.

Es ist klar, dass Oberflächenrauheit und Höhenmodulation auf unterschiedlicher Skalen residieren, insbesondere mit einem Unterschied von zwischen 1 und 5 Größenordnungen.

Alternativ oder ergänzend kann auch vorgesehen sein, dass die Seitenfläche zumindest bereichsweise vorgespannt ist und/oder entlang der Seitenfläche die Kantenfestigkeit des Substratteilelements, insbesondere des Körpers, größer als 100 MPa, bevorzugt größer als 150 MPa, und/oder variabel und/oder konstant über die gesamte Seitenfläche ist.

Alternativ oder ergänzend kann auch vorgesehen sein, dass die Seitenfläche, insbesondere auf einer makroskopischen Skala, plan und/oder gewölbt ist, insbesondere, vorzugsweise in zumindest einer Querschnittsebene senkrecht zur Seitenfläche, zumindest abschnittsweise einen parabelförmigen und/oder kreisförmigen Verlauf und/oder einen Verlauf gemäß einer Gleichung vierten Grades aufweist.

Bei einer gewölbten Seitenfläche können auf diese einwirkende Kräfte besonders vorteilhaft abgeleitet werden und damit die Stabilität der Seitenfläche gesteigert werden.

### Kurzbeschreibung der Figuren

Weitere Merkmale und Vorteile der Erfindung ergeben sich aus der nachfolgenden Beschreibung, in der eine bevorzugte Ausführungsform der Erfindung anhand schematischer Zeichnungen erläutert wird.

Dabei zeigen:
- Fig. 1a: ein bearbeiteter Substratkörper aus dem Stand der Technik in einer Draufsicht;
- Fig. 1b: ein bearbeiteter Substratkörper aus dem Stand der Technik in einer Querschnittsansicht;
- Fig. 2a: ein erstes Substratelement in einer Draufsicht;
- Fig. 2b: das erste Substratelement in einer Querschnittsansicht;
- Fig. 3a: ein zweites Substratelement in einer Draufsicht mit einem Lichtstrahl in einer ersten Konfiguration gemäß dem Stand der Technik;
- Fig. 3b: das zweite Substratelement in einer Draufsicht mit einem Lichtstrahl in einer zweiten Konfiguration;
- Fig. 4a: ein drittes Substratelement in einer Draufsicht mit einem Lichtstrahl in einer dritten Konfiguration gemäß dem Stand der Technik;
- Fig. 4b: das dritte Substratelement in einer Draufsicht mit einem Lichtstrahl in einer vierten Konfiguration;
- Fig. 5a: eine erste Querschnittsansicht eines Raytracing-Modells eines Airy-Strahls in einer ersten Querschnittsebene; und
- Fig. 5b: eine zweite Querschnittsansicht des Raytracing-Modells des Airy-Strahls in einer zweiten Querschnittsebene.

### Beispiele

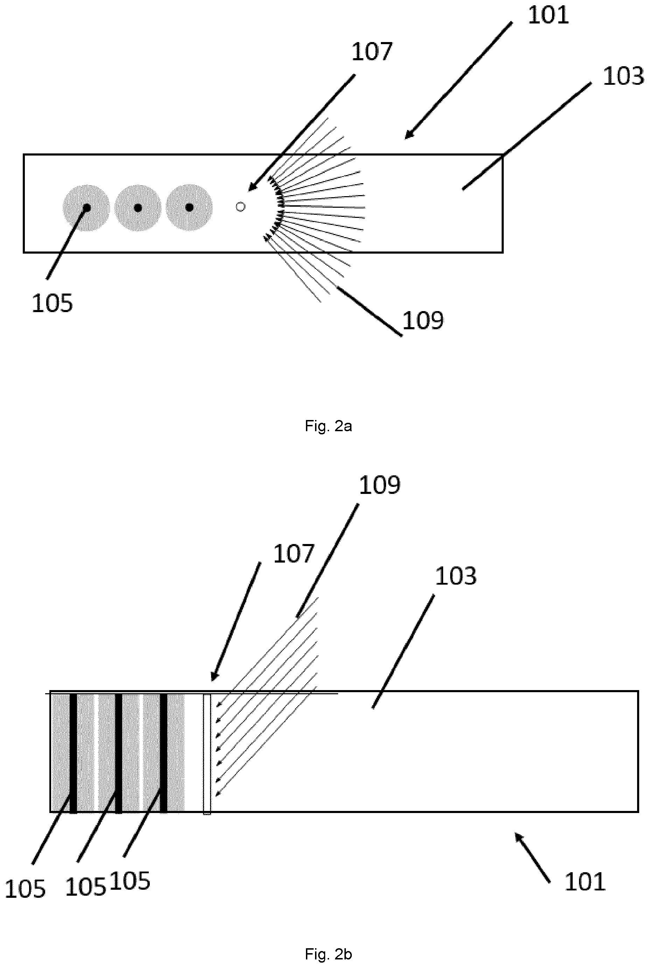

Figur 2a zeigt ein rechteckiges, scheibenförmiges erstes Substratelement 101, beispielsweise ein Glaselement, in einer Draufsicht. Das erste Substratelement 101 umfasst einen Substratkörper 103, beispielsweise einen Glaskörper, der ein Substratmaterial, beispielsweise Glas, aufweist.

Figur 2b zeigt das erste Substratelement 101 in einer senkrecht zur Aufsicht der Figur 2a verlaufenden Querschnittsansicht.

Um das erste Substratelement 101 dazu vorzubereiten, es entlang einer Trennfläche trennen zu können, die in Figur 2b in der Zeichenebene liegt und die durch die Mittelpunkte der kreisförmigen Hohlräume 105 verläuft, sieht das erfindungsgemäß Verfahren vor, einen Linienfokus 107 innerhalb des Substratkörpers 103 derart zu steuern, dass entlang der definierten Trennfläche bereichsweise Substratmaterial des Substratkörpers 103 lokal entfernt und/oder verdrängt wird. Dazu wird der Linienfokus 107 nacheinander innerhalb unterschiedlicher Ortsbereiche des Substratmaterials ausgebildet und dadurch das Substratmaterial jeweils dieser Ortsbereiche entfernt bzw. verdrängt. Der Ortsbereich entspricht dem Bereich der Hohlräumen 105 im vormaligen Substratmaterial. Um die Hohlräume 105 herum können Modifikationen, insbesondere Schädigungen, des Substratkörpers 103 auftreten, ohne dass jedoch Material entfernt bzw. verdrängt werden würde. Beispielsweise können dies Änderungen des Brechungsindex sein.

Benachbarte Ortsbereiche weisen in der Zeichenebene der Figur 2a einen Mitte-Mitte-Abstand zueinander auf, der größer ist als die größte Ausdehnung der Ortsbereiche in der Zeichenebene.

Der Linienfokus 107 wird dabei durch einen Laserstrahl ausgebildet, der wiederum im Bereich des Linienfokus in Form eines Lichtstrahls mit asymmetrischer Strahlzuführung ausgebildet ist. Bei dieser asymmetrischen Strahlzuführung fallen die Teilstrahlen 109 des Lichtstrahls nur aus Richtungen ein, die so gewählt sind, dass sie nicht durch Bereiche des Substratkörpers 103 propagieren, aus denen bereits Substratmaterial entfernt und/oder verdrängt wurde und/oder in die Substratmaterial hineinverdichtet wurde. Mit anderen Worten, in Figur 2a und Figur 2b fallen die Teilstrahlen 109 nur von rechts ein, da die Perforationslöcher von links nach rechts ausgebildet werden.

Der Laserstrahl weist eine im Transparenzbereich des Substratkörpers 103 liegende Wellenlänge von 1030 nm auf und wird von einem Ultrakurzpulslaser erzeugt. Der Ultrakurzpulslaser hat eine Pulslänge von 1 ps.

In einer Ausführungsform könnte das erste Substratelement 101, während das Substratmaterial entfernt bzw. verdrängt wird, von einem Fluid (nicht gezeigt in den Figuren 2a und 2b) umgeben sein, so dass das Fluid an Stelle des entfernten bzw. verdrängt Substratmaterials treten kann. Das heißt, sobald das Substratmaterial entfernt bzw. verdrängt wird, kann bereits das Fluid an dessen Stelle treten. Dadurch wären dann die in Figuren 2a und 2b gezeigten Hohlräume 105 auch komplett mit dem Fluid gefüllt.

In der vorliegenden Erfindung ist die asymmetrische Strahlzuführung damit besonders vorteilhaft. Dies zeigt sich insbesondere bei der Anwesenheit von großflächigen lateralen Störungen und/oder Brechzahlunterschieden. Denn die asymmetrische Strahlzuführung ermöglicht es, dass Teilstrahlen des Lichtstrahls, der den Fokus ausbildet, möglichst nicht oder nur gering von solchen Störungen bzw. Brechzahlunterschieden beeinflusst werden.

Die vorliegende Erfindung kann beispielsweise vorteilhaft dazu eingesetzt werden, Material eines Substratelements nahe eines Übergangs zwischen zwei Brechzahlen zu entfernen und/oder zu verdrängen.

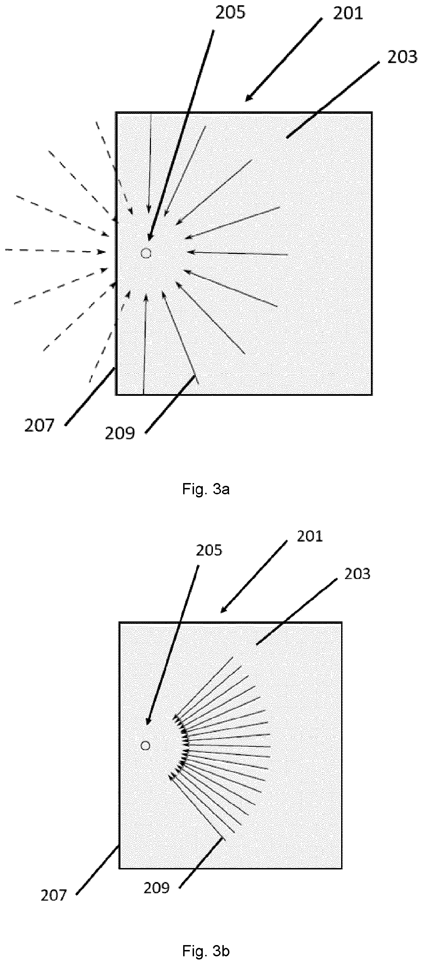

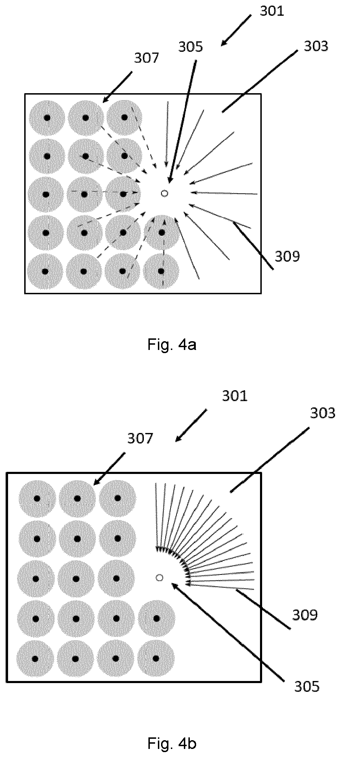

Mit Hilfe der Figuren 3a, 3b, 4a und 4b werden die Vorteile des vorgeschlagenen Verfahrens gegenüber herkömmlichen Realisierungen erläutert, indem verschiedene Konfigurationen des Lichtstrahls bei unterschiedlichen Szenarien betrachtet werden.

Dazu zeigen Fig. 3a und 3b jeweils ein gleiches zweites Substratelement 201 in einer Draufsicht. Das zweite Substratelement 201 umfasst einen Substratkörper 203, beispielsweise einen Glaskörper, der ein Substratmaterial, beispielsweise Glas, aufweist.

Das Substratmaterial des Substratkörpers 203 soll lokal entfernt und/oder verdrängt werden, beispielsweise um ein Trennen des Substratelements 201 vorzubereiten. Dazu wird mit einem Lichtstrahl ein Linienfokus 205 innerhalb des Glasmaterials ausgebildet, um so einen Hohlraum in dem Substratmaterial auszubilden. Der Linienfokus 205 verläuft senkrecht zur Zeichenebene der Fig. 3a und 3b und befindet sich nahe einer Kante 207 des Substratelements 201.

Die Kante 207 stellt einen Übergang zwischen zwei Brechzahlen (in den Figuren 3a und 3b etwa von der des Substratmaterials auf der des das Substratelement 201 umgebenen Mediums) dar.

In Fig. 3a ist der Lichtstrahl in einer ersten Konfiguration, die eine herkömmliche Strahlzuführung des Linienfokus 205 gemäß dem Stand der Technik umfasst. Der Linienfokus 205 wird dabei durch Teilstrahlen 209 gebildet, die (in der Zeichenebene der Fig. 3a) aus allen Richtungen einfallen. Damit verlaufen einige Teilstrahlen, nämlich die, die in Fig. 3a gestrichelt dargestellt sind, zumindest teilweise außerhalb des Substratelements 201. Dies kann infolge des Wechsels des Brechungsindex an der Kante 207 die Ausbildung des Fokus 205 erschweren, oder sogar ganz verhindern.

Der Begriff "aus allen Richtungen" bezieht sich dabei sich auf die Komponente in der transversalen Ebene, d.h. in der Ebene senkrecht zur optischen Achse. Die Komponente entlang der optischen Achse zeigt immer in Propagationsrichtung des Laserstrahls. Oder mit anderen Worten ausgedrückt: In Polarkoordinaten betrachtet überstreicht der Azimutwinkel 360°, also alle Richtungen, und der Polwinkel bewegt sich innerhalb des vom Axikon vorgegebenen Fokussierkegels als maximale Ausdehnung.

In Fig. 3b ist der Lichtstrahl in einer zweiten Konfiguration, die eine asymmetrische Strahlzuführung gemäß der Erfindung umfasst. Der Linienfokus 205 wird dabei durch Teilstrahlen 209 gebildet, die (in der Zeichenebene der Fig. 3b) nur aus bestimmten Richtungen einfallen. Dabei verlaufen die Teilstrahlen 209 für die in Fig. 3b dargestellte Situation komplett innerhalb des Substratelements 201. Dadurch wird die Ausbildung des Fokus 205 besonders effektiv unterstützt. Die asymmetrische Strahlzuführung ermöglicht also in der Nähe der Kante 207 eine stabile Fokusausprägung.

Die vorliegende Erfindung kann beispielsweise auch vorteilhaft dazu eingesetzt werden, Material eines Substratelements nahe großflächiger lateraler Störungen zu entfernen und/oder zu verdrängen.

Dazu zeigen Fig. 4a und 4b jeweils ein gleiches drittes Substratelement 301 in einer Draufsicht. Das dritte Substratelement 301 umfasst einen Substratkörper 303, beispielsweise einen Glaskörper, der ein Substratmaterial, beispielsweise Glas, aufweist.

Das Substratmaterial des Substratkörpers 303 soll lokal entfernt und/oder verdrängt werden. Dazu wird mit einem Lichtstrahl ein Linienfokus 305 innerhalb des Glasmaterials ausgebildet, um so einen Hohlraum in dem Substratmaterial auszubilden. Der Linienfokus 305 verläuft senkrecht zur Zeichenebene der Fig. 4a und 4b und befindet sich nahe von Störungen 307 des Substratelements 301. Die Störungen 307 stellen dabei mehrere im Substratkörper 303 eingebrachte Modifikationen in Form von beispielsweise Veränderungen in der Brechzahl und/oder entferntes Glasmaterial dar.

In Fig. 4a ist der Lichtstrahl in einer dritten Konfiguration, die eine herkömmliche Strahlzuführung des Linienfokus 305 gemäß dem Stand der Technik umfasst. Der Linienfokus 305 wird dabei durch Teilstrahlen 309 gebildet, die (in der Zeichenebene der Fig. 4a) aus allen Richtungen einfallen. Damit verlaufen einige Teilstrahlen, nämlich die, die in Fig. 4a gestrichelt dargestellt sind, zumindest teilweise durch die Störungen 307 hindurch. Dies kann die Ausbildung des Fokus 305 erschweren, oder sogar ganz verhindern.

In Fig. 4b ist der Lichtstrahl in einer vierten Konfiguration, die eine asymmetrische Strahlzuführung gemäß der Erfindung umfasst. Der Linienfokus 305 wird dabei durch Teilstrahlen 309 gebildet, die (in der Zeichenebene der Fig. 4b) nur aus bestimmten Richtungen einfallen. In der Zeichenebene der Fig. 4b verlaufen die Teilstrahlen daher nur im oberen rechten Quadranten. Dabei verlaufen die Teilstrahlen 309 derart, dass sie nicht durch die Störungen 307 verlaufen. Dadurch wird die Ausbildung des Fokus 305 besonders effektiv unterstützt. Die asymmetrische Strahlzuführung ermöglicht also in der Nähe der Störungen 307 eine stabile Fokusausprägung.

Insbesondere ist bei vielen, dicht gesetzten Störungen 307, wie besagte Modifikationen, die Beeinflussung der Teilstrahlen 309, insbesondere in Form von Verschattungen, sehr signifikant. Dementsprechend ist die asymmetrische Strahlzuführung in diesem Fall besonders vorteilhaft. Ein Spezialfall dieser Anwendung ist die Kreuzung, insbesondere T-Kreuzung, zweier Linien. Oder mit anderen Worten, die Kreuzung von Modifikationen, die sich entlang zweier Linien erstrecken. Auch hierfür kann die Erfindung bevorzugt eingesetzt werden, indem die Strahlzuführung geeignet gewählt wird.

Die erste und dritte Konfiguration zeigen daher jeweils einen Lichtstrahl, wie er im Stand der Technik verwendet wird, mit den damit verbundenen Nachteilen. Die Nachteile können mit einem Lichtstrahl überwunden werden, indem für diesen eine Konfiguration gemäß der Erfindung, also wie die zweite und vierte Konfiguration, gewählt wird.

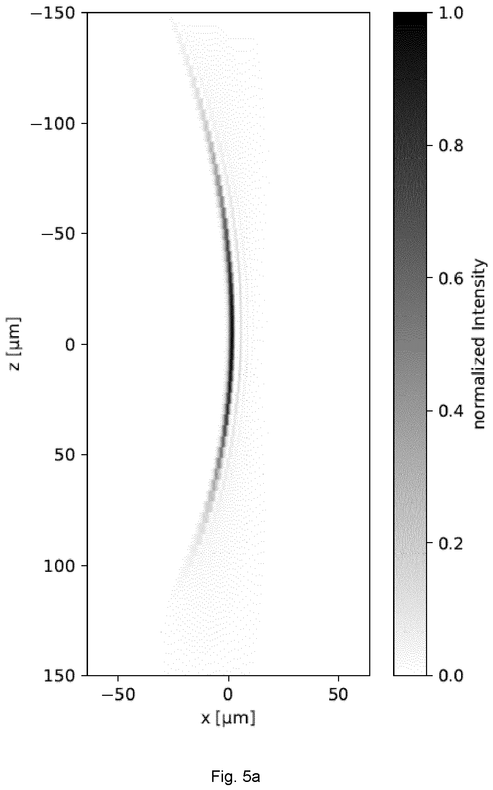

Figur 5a zeigt eine erste Querschnittsansicht eines Raytracing-Modells eines Airy-Strahls in einer ersten Querschnittsebene. Die erste Querschnittsebene verläuft dabei parallel zur Trennfläche eines hypothetischen (z.B. quaderförmigen) Substratelements. D.h., die Trennfläche liegt in der x-z-Ebene (bei y=0) und schneidet den kompletten, gekrümmten Linienfokus. Der Linienfokus hat in Figur 5a seine maximale Intensität in dessen Mitte, also im Bereich um (x=0; z=0). Entsprechend des gekrümmten Linienfokus verlaufen auch die Orts- bzw. Wirkbereiche gleichermaßen gekrümmt. Bei dem erfindungsgemäßen Verfahren folgen vorliegend benachbarte Orts- bzw. Wirkbereiche in positiver x-Richtung aufeinander.

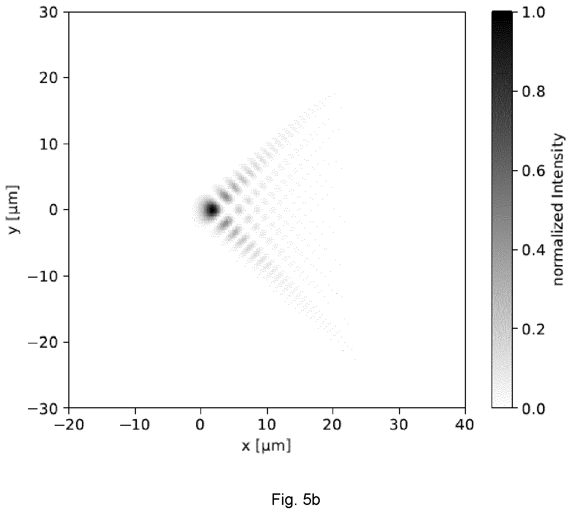

Figur 5b zeigt eine zweite Querschnittsansicht des Raytracing-Modells des Airy-Strahls in einer zweiten Querschnittsebene. Die zweite Querschnittsebene steht senkrecht auf der ersten Querschnittsebene. Beispielsweise könnte dies die Oberfläche des hypothetischen (quaderförmigen) Substratelements sein, oder eine dazu parallel verlaufende Ebene innerhalb des Substratelements. Bei dem erfindungsgemäßen Verfahren folgen vorliegend benachbarte Orts-/Wirkbereiche in positiver x-Richtung aufeinander. Die in Figur 5b dargestellte zweite Querschnittsebene könnte beispielsweise eine erste und/oder zweite spezifische Querschnittsebene gemäß der Erfindung sein. Es ist denkbar, dass sowohl die erste als auch die zweite spezifische Querschnittsebene die in Figur 5b dargestellte zweite Querschnittsebene entspricht. Es könnte beispielsweise gefordert werden, dass benachbarte Orts- bzw. Wirkbereiche in der ersten bzw. zweiten spezifischen Querschnittsebene, mithin also in der zweiten Querschnittsebene der Figur 5b, einen bestimmten Mitte-Mitte-Abstand zueinander aufweisen.

Die Querschnittsebene der Figur 5b schneidet den Linienfokus des Laserstrahls im Bereich um den Punkt (x=0; y=0). Im Bereich positiver x-Werte sind außerdem die lateralen Teilstrahlen des Laserstrahls zu sehen. Wie aus Figur 5b weiter ersichtlich ist, weist der Airy-Strahl dort keine lateralen Komponenten hin zu negativen x-Werten auf. Stattdessen erfolgt die Strahlzuführung entsprechend des erfindungsgemäßen Verfahrens asymmetrisch, in der Situation der Figur 5b also nur aus Teilen des Halbraums mit positiven x-Werten. Dadurch treten bei einem relativen Verschieben des Linienfokus in Richtung der positiven x-Achse keine Teilstrahlen im Bereich vorheriger Kavitäten auf.

Wie bereits erwähnt, wird im Zusammenhang mit der Strahlzuführung bzw. Energiezuführung vorliegend der Begriff "asymmetrisch" im Sinne von "nicht-rotationssymmetrisch" verstanden. Das bedeutet, dass andere Symmetrien damit nicht ausgeschlossen werden. Zum Beispiel hat der nun beschriebene Airy-Strahl eine Spiegelebene parallel zur x-z-Ebene, wie aus Figur 5b ersichtlich ist.

### Bezugszeichenliste

- 1: Substratelement
- 3: Substratkörper
- 5: Hohlraum
- 7: Fokus
- 9: Teilstrahl
- 101: Substratelement
- 103: Substratkörper
- 105: Hohlraum
- 107: Fokus
- 109: Teilstrahl
- 201: Substratelement
- 203: Substratkörper
- 205: Fokus
- 207: Kante
- 209: Teilstrahl
- 301: Substratelement
- 303: Substratkörper
- 305: Fokus
- 307: Störungen
- 309: Teilstrahl

## Patentansprüche

1. Verfahren zum Vorbereiten und/oder Durchführen des Trennens eines Substratelements (101) in wenigstens zwei Substratteilelemente entlang einer Trennfläche, umfassend die Schritte:
- Bereitstellen des Substratelements (101), das zumindest einen zumindest ein Substratmaterial aufweisenden Substratkörper (103) umfasst;
- Steuern zumindest eines Linienfokus (107) innerhalb des Substratkörpers (103) derart, dass entlang der Trennfläche zumindest bereichsweise Substratmaterial des Substratkörpers (103) zumindest lokal entfernt und/oder verdrängt wird;
wobei der Linienfokus (107) zumindest einen Fokus zumindest eines Lichtstrahls darstellt;
wobei der Lichtstrahl zumindest im Bereich des Linienfokus in Form eines Lichtstrahls mit asymmetrischer Strahlzuführung ausgebildet ist;
wobei bei der asymmetrischen Strahlzuführung die Energie asymmetrisch zugeführt wird, und derart ausgestaltet ist, dass der Schwerpunkt der Energieverteilung in wenigstens einer Ebene senkrecht zur Ebene, in der die Strahlausbreitung erfolgt, im Bereich des bisher nicht modifizierten Substratmaterials liegt.

2. Verfahren nach Anspruch 1,
wobei bei der asymmetrischen Strahlzuführung
(i) die Energie asymmetrisch zugeführt wird, und derart ausgestaltet ist, dass der Schwerpunkt der Energieverteilung in wenigstens einer Ebene senkrecht zur Ebene, in der die Strahlausbreitung erfolgt, im Bereich des bisher nicht modifizierten Substratmaterials, also auf der von der vorhergehenden Kavität abgewandten Seite, liegt;
(ii) die Teilstrahlen (109) des Lichtstrahls nur aus einer halben Raumhälfte, oder einem Teil davon, einfallen;
(iii) wobei der Lichtstrahl einen Polwinkel p von 0° < p < 90° aufweist und/oder sich die Teilstrahlen des Lichtstrahls innerhalb eines Azimutwinkel-Bereichs von kleiner als 180°, vorzugsweise von zwischen 85° und 100°, insbesondere von zwischen 90° und 95°, befinden;
(iv) die Teilstrahlen (109) des Lichtstrahls nur aus Richtungen einfallen, die so gewählt sind, dass sie nicht durch Bereiche des Substratkörpers (103) propagieren, aus denen bereits Substratmaterial entfernt und/oder verdrängt wurde und/oder in die Substratmaterial hineinverdichtet wurde;
(v) der Lichtstrahl zumindest eine Spiegelebene parallel zu der Ebene, in der die Strahlausbreitung erfolgt, aufweist;
(vi) der Begriff "asymmetrisch" im Sinne von "nicht-rotationssymmetrisch" zu verstehen ist, insbesondere also andere Symmetrien nicht ausgeschlossen sind;
und/oder
(vii) die Teilstrahlen (109) des Lichtstrahls in jeder zu zumindest einer Oberfläche des Substratelements parallelen Ebene und/oder in jeder zur optischen Achse des Lichtstrahls senkrechten Ebene nur aus einem oder nur aus zwei Quadranten einfallen.

3. Verfahren nach einem der vorangehenden Ansprüche,
wobei der Lichtstrahl zumindest einen Laserstrahl umfasst, der Lichtstrahl zumindest im Bereich des Linienfokus als Airy-Strahl oder als Bessel-Strahl ausgebildet ist und/oder die Laser-Energie entlang der Fokallinie des Linienfokus (107) fokussiert wird.

4. Verfahren nach einem der vorangehenden Ansprüche,
wobei das Steuern des Linienfokus (107) umfasst, dass der Linienfokus (107) nacheinander innerhalb unterschiedlicher Ortsbereiche des Substratmaterials ausgebildet wird und dadurch das Substratmaterial jeweils dieser Ortsbereiche entfernt und/oder verdrängt wird, insbesondere das Substratmaterial in einen Teil des den jeweiligen Ortsbereich umgebenen Substratkörpers hineinverdichtet wird,
wobei vorzugsweise die einzelnen Ortsbereiche, insbesondere in zumindest einer, vorzugsweise senkrecht zur Trennfläche, senkrecht zur optischen Achse des Lichtstrahls und/oder parallel zu zumindest einer ersten Oberfläche des Substratelements (101) verlaufenden, ersten spezifischen Querschnittsebene des Substratelements (101), entlang eines geradlinigen Pfades verlaufen.

5. Verfahren nach Anspruch 4,
wobei der Linienfokus und/oder die Ortsbereiche so gewählt ist bzw. sind, dass die größte Ausdehnung der Ortsbereiche in der ersten spezifischen Querschnittsebene zwischen 0,2 µm und 200 µm, bevorzugt zwischen 0,2 µm und 100 µm, noch bevorzugter zwischen 0,2 µm und 50 µm, noch bevorzugter zwischen 0,3 µm und 20 µm, noch bevorzugter zwischen 0,3 µm und 10 µm, und am bevorzugtesten 0,7 µm, beträgt.

6. Verfahren nach Anspruch 4 oder 5,
wobei jeweils benachbarte Ortsbereiche in der ersten spezifischen Querschnittsebene, insbesondere entlang des Pfades, einen Mitte-Mitte-Abstand zueinander aufweisen, der zwischen dem 1-fachen und 500-fachen, vorzugsweise zwischen dem 1-fachen und 100-fachen, noch bevorzugter zwischen dem 1-fachen und dem 50-fachen, noch bevorzugter zwischen dem 1-fachen und 10-fachen, noch bevorzugter zwischen dem 1,1-fachen und 5-fachen, der größten Ausdehnung der Ortsbereiche in der ersten spezifischen Querschnittsebene entspricht und/oder der zwischen 0,1 µm und 500 µm, bevorzugt zwischen 0,2 µm und 400 µm, noch bevorzugter zwischen 0,2 µm und 200 µm, noch bevorzugter zwischen 0,2 µm und 100 µm, noch bevorzugter zwischen 0,2 µm und 50 µm, noch bevorzugter zwischen 0,4 µm und 20 µm, noch bevorzugter zwischen 1 µm und 7 µm, und am bevorzugtesten zwischen 1 µm und 3 µm, beträgt.

7. Verfahren nach einem der Ansprüche 1 bis 3,
wobei das Steuern des Linienfokus (107) umfasst, dass der Linienfokus (107) nacheinander innerhalb unterschiedlicher Wirkbereiche im Substratelement (101), insbesondere im Substratkörper (103), erzeugt und dadurch das innerhalb jeweils dieser Wirkbereiche angeordnete Substratmaterial entfernt und/oder verdrängt wird, insbesondere das Substratmaterial in einen Teil des den jeweiligen Wirkbereich umgebenen Substratkörpers hineinverdichtet wird, und wobei der Abstand der einzelnen Wirkbereiche derart gewählt ist, dass zumindest unmittelbar benachbarte Wirkbereiche zumindest teilweise überlappen, so dass ein durchgehender, substratmaterialfreier Korridor im Substratmaterial entlang der Trennfläche ausgebildet wird,
wobei vorzugsweise die einzelnen Wirkbereiche, insbesondere in zumindest einer, vorzugsweise senkrecht zur Trennfläche, senkrecht zur optischen Achse des Lichtstrahls und/oder parallel zu zumindest einer zweiten Oberfläche des Substratelements (101) verlaufenden, zweiten spezifischen Querschnittsebene des Substratelements (101), entlang eines geradlinigen Pfades verlaufen.

8. Verfahren nach Anspruch 7,
wobei der Linienfokus (107) und/oder die Wirkbereiche so gewählt ist bzw. sind, dass die größte Ausdehnung der Wirkbereiche in der zweiten spezifischen Querschnittsebene zwischen 0,2 µm und 200 µm, bevorzugt zwischen 0,2 µm und 100 µm, noch bevorzugter zwischen 0,2 µm und 50 µm, noch bevorzugter zwischen 0,3 µm und 20 µm, noch bevorzugter zwischen 0,3 µm und 10 µm, und am bevorzugtesten 0,7 µm, beträgt.

9. Verfahren nach Anspruch 7 oder 8,
wobei jeweils benachbarte Wirkbereiche in der zweiten spezifischen Querschnittsebene, insbesondere entlang des Pfades, einen Mitte-Mitte-Abstand aufweisen, der zwischen dem 0,01-fachen und dem 1,0-fachen, bevorzugt zwischen dem 0,01-fachen und dem 0,5-fachen, der größten Ausdehnung der Wirkbereiche in der zweiten spezifischen Querschnittsebene entspricht und/oder der zwischen 0,002 µm und 200 µm, bevorzugt zwischen 0,002 µm und 100 µm, noch bevorzugter zwischen 0,002 µm und 50 µm, noch bevorzugter zwischen 0,002 µm und 10 µm, noch bevorzugter zwischen 0,002 µm und 1 µm, am bevorzugtesten zwischen 0,005 µm und 0,3 µm, beträgt.

10. Verfahren nach einem der Ansprüche 4 bis 9,
wobei die Ortsbereiche und/oder Wirkbereiche im Substratmaterial zumindest bereichsweise schlauchförmig, zylinderförmig und/oder gekrümmt, insbesondere in zumindest einer Querschnittsebene sichelartig, verlaufen und/oder sich vorzugsweise von der ersten bzw. zweiten Oberfläche des Substratkörpers (103) zur der Oberfläche gegenüberliegenden Oberfläche des Substratkörpers (103) durch den gesamten zwischen den beiden Oberflächen eingeschlossenen Dickenbereich des Substratkörpers (103) hindurch erstrecken.

11. Verfahren nach einem der vorangehenden Ansprüche,
wobei das Steuern des Linienfokus (107) umfasst, dass das Substratelement (101) relativ zu dem zumindest einen Lichtstrahl (109) und/oder zu dem Linienfokus (107) verfahren wird, wodurch vorzugsweise der Linienfokus (107), insbesondere nacheinander oder kontinuierlich, zumindest an den unterschiedlichen Orts- und/oder Wirkbereichen ausgebildet werden kann.

12. Verfahren nach einem der vorangehenden Ansprüche,
wobei der oder die Lichtstrahlen (109) (i) eine Wellenlänge von zwischen 300 nm und 1500 nm, insbesondere 343 nm, 355 nm, 515 nm, 532 nm, 1030 nm oder 1064 nm, aufweist bzw. aufweisen, (ii) eine Wellenlänge aus dem Transparenzbereich des Substratmaterials aufweisen, und/oder (iii) von zumindest einem gepulsten Laser, insbesondere einem Ultrakurzpulslaser, mit einer Pulsdauer von zwischen 200 fs und 50 ps, vorzugsweise von zwischen 500 fs und 10 ps, einer Pulszahl im Burst von zwischen 1 und 10, vorzugsweise 4, eine Repetition Rate von zwischen 1 kHz und 4 GHz, vorzugsweise 40 MHz, und/oder einer Pulsenergie von zwischen 80 µJ/mm und 300 µJ/mm, vorzugsweise 100-230 µJ/mm, insbesondere 180 µJ/mm, emittiert werden.

13. Verfahren nach einem der vorangehenden Ansprüche,
wobei das Substratelement (101) zumindest während das Substratmaterial entfernt und/oder verdrängt wird zumindest teilweise und/oder bereichsweise von zumindest einem Fluid umgeben und/oder zumindest teilweise und/oder bereichsweise innerhalb des Fluids angeordnet ist, so dass das Fluid an Stelle des entfernten bzw. verdrängten Substratmaterials treten kann,
wobei vorzugsweise der Lichtstrahl (109) zumindest eine Wellenlänge umfasst und das Fluid für die Wellenlänge des Lichtstrahls (109) einen Brechungsindex aufweist, der höchstens 30 % vom Brechungsindex des Substratkörpers (103) abweicht, und/oder einen Brechungsindex von zwischen 1,2 und 2,5 aufweist,
insbesondere das Fluid eine Flüssigkeit umfasst, einen Brechungsindex aufweist, der höchstens 20 %, 10 %, 7 %, 5 %, 3 % oder 1 % vom Brechungsindex des Substratkörpers (103) abweicht und/oder einen Brechungsindex von zwischen 1,2 und 2,1, vorzugsweise von zwischen 1,3 und 1,6, aufweist.

14. Verfahren nach einem der vorangehenden Ansprüche,
wobei
(i) das Substratelement ein Glaselement, ein Glaskeramikelement, ein Siliziumelement und/oder ein Saphirelement umfasst oder darstellt und/oder zumindest bereichsweise in Form einer Platte und/oder eines Wafers, insbesondere eines Silizium-Wafers, ausgebildet ist;
(ii) der Substratkörper ein Glaskörper, ein Glaskeramikkörper, ein Siliziumkörper und/oder ein Saphirkörper umfasst oder darstellt;
und/oder
(iii) das Substratmaterial Glas, Glaskeramik, Silizium und/oder Saphir umfasst oder daraus besteht.

15. Substratteilelement, insbesondere hergestellt und/oder herstellbar mit einem Verfahren gemäß einem der Ansprüche 1 bis 14,
umfassend zumindest einen zumindest ein Glasmaterial, Glaskeramikmaterial und/oder Silizium aufweisenden Körper (103), der zumindest eine Seitenfläche aufweist,
wobei die Seitenfläche zumindest bereichsweise eine in der Höhe modulierte Oberfläche aufweist;
wobei die Seitenfläche zumindest bereichsweise eine Oberflächenrauheit aufweist und die Variation der Oberfläche in Folge der Oberflächenrauheit zwischen 1 und 5 Größenordnungen geringer als die Variation der Oberfläche in Folge der Höhenmodulation ist,
wobei vorzugsweise
(a) die Höhenmodulation der Oberfläche eine wellenförmige Oberfläche darstellt und/oder die Variation der Oberfläche in Folge der Höhen-Modulation innerhalb eines vorgebbaren Wertebereichs liegt, insbesondere innerhalb eines Wertebereichs von 0,5 µm bis 100 µm, bevorzugt innerhalb eines Wertebereichs von 0,5 µm bis 50 µm;
(b) (i) die Seitenfläche zumindest bereichsweise eine, vorzugsweise mittlere, Rautiefe von zwischen 0,01 µm bis 30 µm, bevorzugt von zwischen 0,05 µm bis 10 µm, am bevorzugtesten von zwischen 0,05 µm bis 5 µm, RZ aufweist, (ii) die Oberflächenrauheit eine mittlere Oberflächenrauheit ist, (iii) die Variation der Oberfläche in Folge der Rautiefe zwischen 1 und 5, vorzugsweise 2 oder 3, Größenordnungen geringer als die Variation der Oberfläche in Folge der Höhenmodulation ist, und/oder (iv) die Variation der Oberfläche in Folge der Oberflächenrauheit 2 oder 3 Größenordnungen geringer als die Variation der Oberfläche in Folge der Höhenmodulation ist;
(c) die Seitenfläche zumindest bereichsweise vorgespannt ist und/oder entlang der Seitenfläche die Kantenfestigkeit des Substratteilelements, insbesondere des Körpers (103), größer als 100 MPa, bevorzugt größer als 150 MPa, und/oder variabel oder konstant über die gesamte Seitenfläche ist;
und/oder
(d) die Seitenfläche, insbesondere auf einer makroskopischen Skala, plan und/oder gewölbt ist, insbesondere, vorzugsweise in zumindest einer Querschnittsebene senkrecht zur Seitenfläche, zumindest abschnittsweise einen parabelförmigen und/oder kreisförmigen Verlauf und/oder einen Verlauf gemäß einer Gleichung vierten Grades aufweist.

## Claims

1. Method for preparing and/or performing separation of a substrate element (101) into at least two substrate sub-elements along a separation surface, comprising the steps of:
providing the substrate element (101) comprising at least one substrate body (103) which comprises at least one substrate material;
controlling at least one line focus (107) within the substrate body (103) such that substrate material of the substrate body (103) is at least locally removed and/or displaced along the separation surface at least in areas,
wherein the line focus (107) represents at least one focus of at least one light beam,
wherein the light beam, at least in the area of the line focus, is in the form of a light beam with asymmetrical beam supply,
wherein in the asymmetrical beam supply energy is supplied asymmetrically and is configured in such a way that the centroid of the energy distribution in at least one plane perpendicular to the plane, in which the beam propagation takes place, lies in the area of the so far unmodified substrate material.

2. Method according to claim 1,
wherein in the asymmetrical beam supply
(i) the energy is supplied asymmetrically and is configured in such a way that the centroid of the energy distribution in at least one plane perpendicular to the plane in which the beam propagation takes place lies in the area of the so far unmodified substrate material, i.e., on the side facing away from the preceding cavity;
(ii) the sub-beams (109) of the light beam are incident only from half of a half space or a part thereof;
(iii) the light beam has a pole angle p of 0° < p < 90° and/or the sub-beams of the light beam are arranged within an azimuth angle range of less than 180°, preferably between 85° and 100°, in particular between 90° and 95°;
(iv) the sub-beams (109) of the light beam are incident only from directions which are selected such that they do not propagate through areas of the substrate body (103) from which substrate material has already been removed and/or displaced and/or into which substrate material has been compacted;
(v) the light beam has at least one mirror plane parallel to the plane in which the beam propagation takes place;
(vi) the term "asymmetrical" is to be understood in the sense of "non-rotationally symmetric", in particular other symmetries are not excluded; and/or
(vii) the sub-beams (109) of the light beam are incident from only one or only two quadrants in each plane parallel to at least one surface of the substrate element and/or in each plane perpendicular to the optical axis of the light beam.

3. Method according to any one of the preceding claims,
wherein the light beam comprises at least one laser beam, the light beam is formed as an Airy beam or as a Bessel beam at least in the area of the line focus and/or the laser energy is focused along the focal line of the line focus (107).

4. Method according to any one of the preceding claims,
wherein controlling the line focus (107) comprises forming the line focus (107) successively within different local areas of the substrate material and thereby removing and/or displacing the substrate material of each of these local areas, in particular compacting the substrate material into a part of the substrate body surrounding the respective local area,
wherein preferably the individual local areas, in particular in at least one first specific cross-sectional plane of the substrate element (101) extending preferably perpendicularly to the separation surface, perpendicularly to the optical axis of the light beam and/or parallel to at least a first surface of the substrate element (101), extend along a rectilinear path.

5. Method according to claim 4,
wherein the line focus and/or the local areas is/are selected such that the greatest extent of the local areas in the first specific cross-sectional plane is between 0.2 µm and 200 µm, preferably between 0.2 µm and 100 µm, more preferably between 0.2 µm and 50 µm, even more preferably between 0.3 µm and 20 µm, even more preferably between 0.3 µm and 10 µm, and most preferably 0.7 µm.

6. Method according to claim 4 or 5,
wherein respective adjacent local areas in the first specific cross-sectional plane, in particular along the path, have a center-to-center distance from one another which is between 1 times and 500 times, preferably between 1 times and 100 times, more preferably between 1 times and 50 times, even more preferably between 1 times and 10 times, even more preferably between 1.1 times and 5 times, of the greatest extent of the local areas in the first specific cross-sectional plane and/or which is between 0.1 µm and 500 µm, preferably between 0.2 µm and 400 µm, even more preferably between 0.2 µm and 200 µm, even more preferably between 0.2 µm and 100 µm, even more preferably between 0.2 µm and 50 µm, even more preferably between 0.4 µm and 20 µm, even more preferably between 1 µm and 7 µm, and most preferably between 1 µm and 3 µm.

7. Method according to any one of claims 1 to 3,
wherein controlling the line focus (107) comprises generating the line focus (107) successively within different effective areas in the substrate element (101), in particular in the substrate body (103), and thereby removing and/or displacing the substrate material arranged within each of these effective areas, in particular compacting the substrate material into a part of the substrate body surrounding the respective effective area, and wherein the spacing of the individual effective areas is selected in such a way that at least directly adjacent effective areas at least partially overlap, so that a continuous, substrate material-free corridor is formed in the substrate material along the separation surface,
wherein preferably the individual effective areas, in particular in at least one second specific cross-sectional plane of the substrate element (101) which preferably extends perpendicular to the separation surface, perpendicular to the optical axis of the light beam and/or parallel to at least one second surface of the substrate element (101), extend along a rectilinear path.

8. Method according to claim 7,
wherein the line focus (107) and/or the effective areas is/are selected such that the greatest extent of the effective areas in the second specific cross-sectional plane is between 0.2 µm and 200 µm, preferably between 0.2 µm and 100 µm, more preferably between 0.2 µm and 50 µm, even more preferably between 0.3 µm and 20 µm, even more preferably between 0.3 µm and 10 µm, and most preferably 0.7 µm.

9. Method according to claim 7 or 8,
wherein respective adjacent effective areas in the second specific cross-sectional plane, in particular along the path, have a center-to-center distance which corresponds between 0.01 and 1.0 times, preferably between 0.01 and 0.5 times, the greatest extent of the effective areas in the second specific cross-sectional plane and/or which is between 0.002 µm and 200 µm, preferably between 0.002 µm and 100 µm, more preferably between 0.002 µm and 50 µm, even more preferably between 0.002 µm and 10 µm, even more preferably between 0.002 µm and 1 µm, most preferably between 0.005 µm and 0.3 µm.

10. Method according to any one of claims 4 to 9,
wherein the local areas and/or the effective areas in the substrate material extend at least in areas in a tubular, cylindrical and/or curved manner, in particular in a sickle-like manner in at least one cross-sectional plane, and/or preferably extend from the first or second surface of the substrate body (103) to the surface of the substrate body (103) opposite the surface over the entire thickness area of the substrate body (103) enclosed between the two surfaces.

11. Method according to any one of the preceding claims,
wherein controlling the line focus (107) comprises moving the substrate element (101) relative to the at least one light beam (109) and/or to the line focus (107), whereby preferably the line focus (107) can be formed, in particular successively or continuously, at least at the different local and/or effective areas.

12. Method according to any one of the preceding claims,
wherein the light beam(s) (109) (i) has/have a wavelength of between 300 nm and 1500 nm, in particular 343 nm, 355 nm, 515 nm, 532 nm, 1030 nm or 1064 nm, (ii) has/have a wavelength from the transparency range of the substrate material, and/or (iii) are emitted from at least one pulsed laser, in particular an ultrashort pulse laser, with a pulse duration of between 200 fs and 50 ps, preferably between 500 fs and 10 ps, a number of pulses in the burst of between 1 and 10, preferably 4, a repetition rate of between 1 kHz and 4 GHz, preferably 40 MHz, and/or a pulse energy of between 80 µJ/mm and 300 µJ/mm, preferably 100-230 µJ/mm, more preferably 180 µJ/mm.

13. Method according to any one of the preceding claims,
wherein the substrate element (101), at least while the substrate material is removed and/or displaced, is at least partially and/or in areas surrounded by at least one fluid and/or is at least partially and/or in areas arranged within the fluid, so that the fluid can occupy the place of the removed and/or displaced substrate material,
wherein preferably the light beam (109) comprises at least one wavelength and the fluid has a refractive index for the wavelength of the light beam (109) which deviates at most 30% from the refractive index of the substrate body (103) and/or has a refractive index of between 1.2 and 2.5,
wherein in particular the fluid comprises a liquid, has a refractive index which deviates at most 20%, 10%, 7%, 5%, 3% or 1% from the refractive index of the substrate body (103) and/or has a refractive index of between 1.2 and 2.1, preferably between 1.3 and 1.6.

14. Method according to any one of the preceding claims, wherein
(i) the substrate element comprises or represents a glass element, a glass-ceramic element, a silicon element and/or a sapphire element and/or is formed at least in areas in the form of a plate and/or a wafer, in particular a silicon wafer;
(ii) the substrate body comprises or represents a glass body, a glass-ceramic body, a silicon body and/or a sapphire body; and/or
(iii) the substrate material comprises or consists of glass, glass ceramic, silicon and/or sapphire.

15. Substrate sub-element, in particular manufactured and/or manufacturable by a method according to any one of claims 1 to 14,
comprising at least one body (103) which comprises at least one glass material, glass ceramic material and/or silicon and has at least one side surface,
wherein the side surface comprises, at least in areas, a surface modulated in height,
wherein the side surface has at least in areas a surface roughness and the variation of the surface as a result of the surface roughness is between 1 and 5 orders of magnitude less than the variation of the surface as a result of the height modulation,
wherein preferably
(a) the height modulation of the surface represents an undulating surface and/or the variation of the surface as a result of the height modulation is within a predeterminable range of values, in particular within a range of values from 0.5 µm to 100 µm, preferably within a range of values from 0.5 µm to 50 µm,
(b) (i) the side surface has, at least in areas, a preferably average roughness depth of between 0.01 µm to 30 µm, preferably of between 0.05 µm to 10 µm, most preferably of between 0.05 µm to 5 µm, RZ; (ii) the surface roughness is an average surface roughness, (iii) the variation of the surface as a result of the roughness depth is between 1 and 5, preferably 2 or 3, orders of magnitude less than the variation of the surface as a result of the height modulation, and/or (iv) the variation of the surface as a result of the surface roughness is 2 or 3 orders of magnitude less than the variation of the surface as a result of the height modulation,
(c) the side surface is at least in areas biased and/or along the side surface the edge strength of the substrate sub-element, in particular of the body (103), is greater than 100 MPa, preferably greater than 150 MPa, and/or is variable or constant over the entire side surface, and/or
(d) the side surface, in particular on a macroscopic scale, is planar and/or curved, in particular, preferably in at least one cross-sectional plane perpendicular to the side surface, has at least in areas a parabolic and/or circular shape and/or a shape according to a fourth degree equation.

## Revendications

1. Procédé de préparation et/ou de réalisation de la séparation d'un élément de substrat (101) en au moins deux sous-éléments de substrat le long d'une surface de séparation, comprenant les étapes :
- fournir l'élément de substrat (101), qui comprend au moins un corps de substrat (103) comportant au moins un matériau de substrat ;
- commander au moins un foyer linéaire (107) à l'intérieur du corps de substrat (103) de sorte que, le long de la surface de séparation, au moins par zones, le matériau de substrat du corps de substrat (103) soit au moins localement retiré et/ou déplacé ;
dans lequel le foyer linéaire (107) représente au moins un foyer d'au moins un faisceau lumineux ;
dans lequel le faisceau lumineux est conçu au moins dans la zone du foyer linéaire sous la forme d'un faisceau lumineux avec une alimentation de faisceau asymétrique ;
dans lequel lors de l'alimentation de faisceau asymétrique, l'énergie est fournie de manière asymétrique et étant conformée de sorte que le centre de gravité de la distribution d'énergie se trouve dans au moins un plan perpendiculaire au plan dans lequel la propagation de faisceau est effectuée dans la zone du matériau de substrat non modifié jusqu'à présent.

2. Procédé selon la revendication 1,
dans lequel lors de l'alimentation asymétrique
(i) l'énergie est fournie de manière asymétrique et est conformée de sorte que le centre de gravité de la distribution d'énergie se trouve dans au moins un plan perpendiculaire au plan dans lequel la propagation de faisceau est effectuée, dans la zone du matériau de substrat non modifié jusqu'à présent, c'est-à-dire du côté opposé à la cavité précédente ;
(ii) les rayons partiels (109) du faisceau lumineux ne sont incidents que depuis une moitié d'espace, ou d'une partie de celle-ci ;
(iii) le faisceau lumineux présente un angle polaire p dans la gamme 0° < p < 90° et/ou les faisceaux partiels du faisceau lumineux se trouvent dans une plage d'angle azimutal inférieure à 180°, de préférence entre 85° et 100°, en particulier entre 90° et 95° ;
(iv) les rayons partiels (109) du faisceau lumineux sont incidents uniquement depuis des directions qui sont sélectionnées de sorte qu'ils ne se propagent pas à travers des zones du corps de substrat (103) dont le matériau de substrat a déjà été retiré et/ou déplacé et/ou compacté jusque dans le matériau de substrat ;
(v) le faisceau lumineux présente au moins un plan miroir parallèle au plan dans lequel la propagation du faisceau est effectuée ;
(vi) le terme « asymétrique » doit être compris dans le sens de « qui n'est pas à symétrie de rotation », en particulier d'autres symétries ne sont pas exclues ;
tt/ou
(vii) dans chaque plan parallèle à au moins une surface de l'élément de substrat et/ou dans chaque plan perpendiculaire à l'axe optique du faisceau lumineux, les rayons partiels (109) du faisceau lumineux ne sont incidents que depuis un ou deux quadrants.

3. Procédé selon l'une des revendications précédentes,
dans lequel le faisceau lumineux comprend au moins un faisceau laser qui est conçu comme un faisceau d'Airy ou un faisceau de Bessel au moins dans la zone du foyer linéaire et/ou l'énergie laser est focalisée le long de la ligne focale du foyer linéaire(107) .

4. Procédé selon l'une des revendications précédentes,
dans lequel la commande du foyer linéaire (107) comprend la formation du foyer linéaire (107) successivement à l'intérieur de différentes zones locales du matériau de substrat et ainsi le retrait et/ou le déplacement du matériau de substrat de chacune ces zones locales, en particulier le matériau du substrat est compacté dans une partie du corps de substrat qui entoure la zone locale respective,
dans lequel de préférence les zones locales individuelles s'étendent le long d'un chemin rectiligne, en particulier dans au moins un premier plan en coupe transversale spécifique de l'élément de substrat (101), qui s'étend de préférence perpendiculairement à la surface de séparation, perpendiculairement à l'axe optique du faisceau lumineux et/ou parallèlement à au moins une première surface de l'élément de substrat (101).

5. Procédé selon la revendication 4,
dans lequel le foyer linéaire et/ou les zones locales sont choisis de sorte que la plus grande extension des zones locales dans le premier plan en coupe transversale spécifique soit comprise entre 0,2 µm et 200 µm, de préférence entre 0,2 µm et 100 µm, encore plus préférablement entre 0,2 µm et 50 µm, encore plus préférablement entre 0,3 µm et 20 µm, encore plus préférablement entre 0,3 µm et 10 µm, et de manière préférée entre toutes 0,7 µm.

6. Procédé selon la revendication 4 ou 5,
dans lequel des zones locales respectivement adjacentes dans le premier plan en coupe transversale spécifique, en particulier le long du chemin, présentent entre elles une distance centre à centre qui correspond entre 1 fois et 500 fois, de préférence entre 1 fois et 100 fois, encore plus préférablement entre 1 fois et 50 fois, encore plus préférablement entre 1 fois et 10 fois, encore plus préférablement entre 1,1 fois et 5 fois, à la plus grande extension des zones locales dans le premier plan en coupe transversale spécifique et/ou qui vaut entre 0,1 µm et 500 µm, de préférence entre 0,2 µm et 400 µm, encore plus préférablement entre 0,2 µm et 200 µm , encore plus préférablement entre 0,2 µm et 100 µm, encore plus préférablement entre 0,2 µm et 50 µm, encore plus préférablement entre 0,4 µm et 20 µm, encore plus préférablement entre 1 µm et 7 µm, et de manière préférée entre toutes entre 1 µm et 3 µm.

7. Procédé selon l'une des revendications 1 à 3,
dans lequel la commande du foyer linéaire (107) comprend la génération du foyer linéaire (107) successivement à l'intérieur de différentes zones actives dans l'élément de substrat (101), en particulier dans le corps de substrat (103), et ainsi le retrait et/ou le déplacement du matériau de substrat disposé à l'intérieur de chacune de ces zones actives, en particulier le matériau de substrat est compacté jusque dans une partie du corps de substrat qui entoure la zone active respective, et la distance entre les zones actives individuelles est sélectionnée de sorte qu'au moins des zones actives immédiatement adjacentes se chevauchent au moins partiellement de façon à former un couloir continu, exempt de matériau de substrat dans le matériau de substrat le long de la surface de séparation,
dans lequel de préférence les zones actives individuelles, s'étendent le long d'un chemin rectiligne en particulier dans au moins un deuxième plan de coupe transversale spécifique de l'élément de substrat (101), qui s'étend de préférence perpendiculairement à la surface de séparation, perpendiculairement à l'axe optique du faisceau lumineux et/ou parallèlement à au moins une deuxième surface de l'élément de substrat (101).

8. Procédé selon la revendication 7,
dans lequel le foyer linéaire (107) et/ou les zones actives sont choisis de telle sorte que la plus grande extension des zones actives dans le deuxième plan en coupe transversale spécifique soit comprise entre 0,2 µm et 200 µm, de préférence entre 0,2 µm et 100 µm, encore plus préférablement entre 0,2 µm et 50 µm, encore plus préférablement entre 0,3 µm et 20 µm, encore plus préférablement entre 0,3 µm et 10 µm, et de manière préférée entre toutes soit de 0,7 µm.

9. Procédé selon la revendication 7 ou 8,
dans lequel les zones actives respectivement adjacentes dans le deuxième plan de coupe transversale spécifique, en particulier le long du chemin, présentent une distance centre à centre qui correspond entre 0,01 fois et 1,0 fois, de préférence entre 0,01 fois et 0,5 fois à la plus grande extension des zones actives dans le deuxième plan de coupe transversale spécifique et/ou qui vaut entre 0,002 µm et 200 µm, de préférence entre 0,002 µm et 100 µm, encore plus préférablement entre 0,002 µm et 50 µm, encore plus préférablement entre 0,002 µm et 10 µm, encore plus préférablement entre 0,002 µm et 1 µm, de manière préférée entre toutes entre 0,005 µm et 0,3 µm.

10. Procédé selon l'une des revendications 4 à 9,
dans lequel les zones locales et/ou les zones actives dans le matériau de substrat s'étendent de manière au moins partiellement tubulaire, cylindrique et/ou incurvée, en particulier falciforme dans au moins un plan de coupe transversale, et/ou s'étendent de préférence de la première ou de la deuxième surface du corps de substrat (103) jusqu'à la surface opposée à la surface du corps de substrat (103) à travers toute la zone d'épaisseur du corps de substrat (103) qui est enfermée entre les deux surfaces.

11. Procédé selon l'une des revendications précédentes,
dans lequel la commande du foyer linéaire (107) comprend le déplacement de l'élément de substrat (101) par rapport à l'au moins un faisceau lumineux (109) et/ou au foyer linéaire (107), de façon à pouvoir de préférence former le foyer linéaire (107), en particulier successivement ou en continu, au moins dans les différents zones locales et/ou actives.

12. Procédé selon l'une des revendications précédentes,
dans lequel le ou les rayons lumineux (109) (i) ont une longueur d'onde comprise entre 300 nm et 1500 nm, en particulier de 343 nm, 355 nm , 515 nm, 532 nm , 1030 nm ou 1064 nm, (ii) ont une longueur d'onde depuis la zone de transparence du matériau de substrat, et/ou (iii) sont émis par au moins un laser pulsé, notamment un laser à impulsions ultra-courtes, de durée d'impulsion comprise entre 200 fs et 50 ps, de préférence entre 500 fs et 10 ps, de nombre d'impulsions dans la salve compris entre 1 et 10, de préférence de 4, un taux de répétition compris entre 1 kHz et 4 GHz, de préférence de 40 MHz, et/ou une énergie d'impulsion comprise entre 80 pj/mm et 300 µJ/mm, de préférence 100 à 230 µJ/mm, en particulier 180 µJ/mm.

13. Procédé selon l'une des revendications précédentes,
dans lequel l'élément de substrat (101) est entouré au moins partiellement et/ou par zones par au moins un fluide et/ou est disposé au moins partiellement et/ou par zones à l'intérieur du fluide au moins, pendant que le matériau de substrat est retiré et/ou déplacé, de sorte que le fluide remplace le matériau de substrat retiré ou déplacé,
dans lequel, de préférence, le faisceau lumineux (109) a au moins une longueur d'onde et le fluide a pour la longueur d'onde du faisceau lumineux (109) un indice de réfraction qui s'écarte au maximum de 30 % de l'indice de réfraction du corps de substrat (103), et/ou a un indice de réfraction compris entre 1,2 et 2,5,
en particulier le fluide comprend un liquide, ayant un indice de réfraction qui s'écarte au maximum de 20 %, 10 %, 7 %, 5 %, 3 % ou 1 % de l'indice de réfraction du corps de substrat (103) et/ou un indice de réfraction compris entre 1,2 et 2,1, de préférence entre 1,3 et 1,6.

14. Procédé selon l'une des revendications précédentes, dans lequel
(i) l'élément de substrat comprend ou représente un élément en verre, un élément en vitrocéramique, un élément en silicium et/ou un élément en saphir et/ou est conçu au moins par zones sous la forme d'une plaque et/ou d'une plaquette de semiconducteur, en particulier d'une plaquette de silicium ;
(ii) le corps de substrat comprend ou représente un corps en verre, un corps en vitrocéramique, un corps en silicium et/ou un corps en saphir ;
et/ou
(iii) le matériau de substrat comprend ou est constitué de verre, vitrocéramique, silicium et/ou saphir.

15. Sous-élément de substrat, notamment fabriqué et/ou pouvant être fabriqué à l'aide d'un procédé selon l'une des revendications 1 à 14, comprenant
au moins un corps (103) qui comporte au moins un matériau en verre, en vitrocéramique et/ou en silicium et qui comporte au moins une surface latérale,
dans lequel la surface latérale comporte au moins par zones une surface modulée en hauteur ;
dans lequel la surface latérale présente au moins par zones une rugosité de surface et la variation de la surface résultant de la rugosité de surface étant inférieure entre 1 et 5 ordres de grandeur à la variation de la surface résultant de la modulation de hauteur,
dans lequel de préférence
(a) la modulation de hauteur de la surface représente une surface ondulée et/ou la variation de la surface résultant de la modulation de hauteur est située dans une plage de valeurs prédéterminée, en particulier dans une plage de valeurs de 0,5 um à 100 um, de préférence dans une plage de valeurs de 0,5 µm à 50 µm ;
(b) (i) la surface latérale présente au moins par zones une profondeur de rugosité RZ, de préférence moyenne, comprise entre 0,01 µm et 30 µm, de préférence entre 0,05 µm et 10 µm, de manière la plus préférée entre toutes entre 0,05 µm et 5 µm, (ii) la rugosité de surface est une rugosité de surface moyenne, (iii) la variation de la surface résultant de la profondeur de rugosité est inférieure à la variation de la surface résultant de la modulation de hauteur entre 1 et 5, de préférence de 2 ou 3, ordres de grandeur, et/ou (iv) la variation de la surface résultant de la rugosité de surface est inférieure à la variation de surface résultant de la modulation de hauteur de 2 ou 3 ordres de grandeur ;
(c) la surface latérale est précontrainte au moins par zones et/ou, le long de la surface latérale, la résistance de bord du sous-élément de substrat, en particulier du corps (103), est supérieure à 100 MPa, de préférence supérieure à 150 MPa, et/ou est variable ou constante sur toute la surface latérale ; et/ou
(d) la surface latérale, en particulier à l'échelle macroscopique, est plane et/ou incurvée, en particulier, de préférence dans au moins un plan en coupe transversale perpendiculaire à la surface latérale, présentant au moins par portions une allure parabolique et/ou circulaire et/ou une allure selon une équation du quatrième degré.
